# EUROPEAN PATENT APPLICATION

(11) **EP 3 065 189 A1**
(43) Date of publication of application: **07.09.2016**
(21) Application number: 15157766.5
(22) Date of filing: 05.03.2015
(51) Int. Cl.: H01L 51/30, H01L 51/42

(54) **Novel hole transport materials and optoelectronic devices containing the same**

(71) Applicant: SOLARONIX SA, 1170 Aubonne (CH)
(72) Inventor: Paek, Sanghyun, 445-855 Hwaseong-si (KR); Abate, Antonio, 20129 Milano (IT); Nazeeruddin, Mohammad Khaja, 1024 Ecublens (CH); Graetzel, Michael, 1025 St-Sulpice (CH)
(74) Representative: Schneiter, Sorin

(57) **Abstract**

The present invention concerns novel silolothiophene-bridged triphenylamines and related compounds and their use as hole transport materials (HTM), for example in optoelectronic and/or electrochemical devices. These materials are particularly useful in organic-inorganic perovskite-based solid state solar cells. Preferred compounds are:

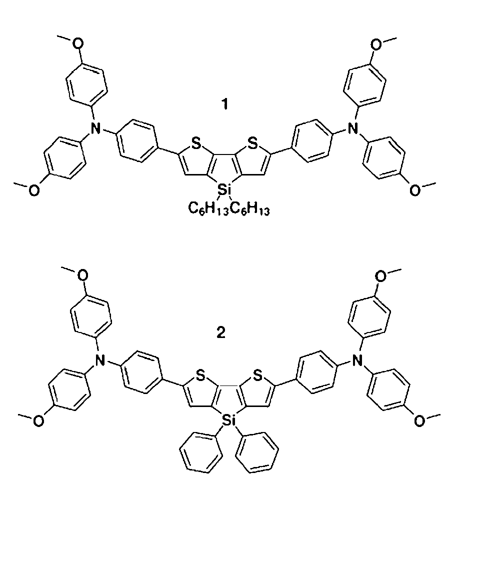

## Description

### Technical Field

The present invention relates to novel organic compounds, the use of these compound as hole transport materials, optoelectronic and/or electrochemical devices comprising these compounds, in particular solar cells, such as solid state solar cells comprising the novel compounds.

### Background Art and Problems Solved by the Invention

The sensitized solar cell is attracting wide spread attention as a promising new generation of photovoltaic technology. Mimicking the principle of natural photosynthesis, its ecological and economical fabrication processes make it an attractive and credible alternative to conventional photovoltaic systems (Gratzel, M. Accounts Chem Res 2009, 42, 1788-1798.). These devices generally comprise a mesoporous photoanode with an organic and/or inorganic light harvester, a redox electrolyte or solid-state hole conductor, and a counter electrode.

Recently, bulk layers of organometallic halide perovskite based on tin (CsSnX₃), or lead (CH₃NH₃PbX₃) have been introduced as semiconducting pigment for light harvesting, resulting in high power conversion efficiencies (PCE) (Chung et al., Nature. 2012, 485, 486-489; Kojima et al., J. Am. Chem. Soc. 2009, 131, 6050-6051; Etgar et al., J. Am. Chem. Soc. 2012, 134, 17396-17399; Kim et al., Sci. Rep. 2012, 2, 591:1-7; Lee et al., Science 2012, 338, 643-647).

The recent 20% PCE barrier breaking proved that these materials can compete with long-established inorganic photovoltaics, such as silicon, cadmium telluride and copper indium gallium selenide. In addition, more similar to organic photovoltaics, perovskites allow preparing solar cells from solution processing, which is particularly desired to deliver a low-cost technology.

Perovskite-based and other types of solid state solar cells generally contain an organic hole transport material layer, for transporting holes created by charge separation at the light harvester to the counter electrode and/or cathode for filling up by incoming electrons, thereby closing the electric circuit and rendering the devices regenerative.

Currently most performing solid state device use doped Spiro-OMeTAD (2,2',7,7'-tetrakis(N,N-di-p-methoxyphenyl amine)-9,9-spirobifluorene) as a hole transport material (HTM). The relatively low PCE of solid state devices was often ascribed to the low hole mobility in Spiro-OMeTAD, which causes interfacial recombination losses by two orders of magnitude higher than in electrolyte-based, dye-sensitized solar cells (DSCCs). Attempts were made to find an alternate organic HTM having higher charge carrier mobility and matching HOMO level to replace Spiro-OMeTAD. In most of the cases, it is difficult to compete with the performances equivalent to Spiro-OMeTAD-based devices, generally due to incomplete pore filling. The ideal conditions to be fulfilled by HTM in order to give good PV performance are sufficient hole mobility, thermal and UV stability, and well-matched HOMO (highest occupied molecular orbital) energy level to the semiconductor light absorbers.

More recently a number of studies indicated that the hole transporting materials (HTMs) can play a key role in controlling the long-term stability of PSCs. It was demonstrated that PSCs are more stable if the organic semiconductors are replaced by carbon as HTMs. Furthermore, it was shown that employing new dopant-free organic HTMs significantly improves the device stability compared to the commonly used chemical doped spiro-OMeTAD.

In view of the above, it is an objective of the present invention to provide novel HTMs, preferably resulting in devices with improved stability and life time and reduced degradation over time. It is also an objective to provide an HTM that provides solar cells exhibiting excellent PCEs.

The present invention addresses the problems depicted above.

### Summary of the Invention

In an aspect, the present invention provides a compound selected from compounds of formula (Ia) and (Ib): 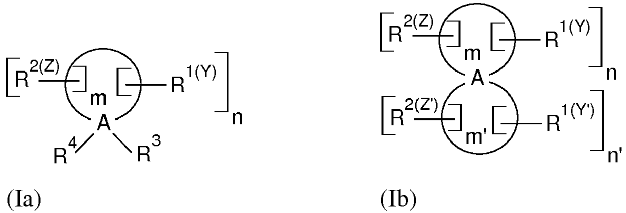 wherein the ring in formula (Ia) and the rings in formula (Ib) represent each an aromatic ring or ring system optionally comprising one or more heteroatoms; wherein A is part of said aromatic ring or ring systems and is selected from a Si and a C atom, preferably Si; The heteroatoms of said aromatic ring or ring system are preferably selected independently from O, S, Si and/or N, more preferably from O, S and/or N. Said optional ring heteroatoms are in addition to Si, in case A is Si.
R^{1(Y)} and R^{2(Z)}, are substituents or hydrogen atoms (H) bound to said aromatic ring or ring system; R^{1(Y')}, and R^{2(Z')} in formulae (Ib), are independently defined as R^{1(Y)} and R^{2(Z)};
n and m, are integers, wherein n+m and is the maximum number of substituents that can be supported on the respective aromatic ring or ring system; wherein, in formulae (Ib), n' and m' and n'+m' are defined, independently, as n, m, and n+m, respectively;
Y and Z are, independently Y from Z, consecutive integers from the set of integers {1...n} and {1...m}, respectively, so that there are n+m substituents, or H, R¹⁽¹⁾ (Y=1) to R¹⁽ⁿ⁾ (Y=n) and R²⁽¹⁾ (Z=1) to R^{2(m)} (Z=m);
wherein Y' and Z' are, independently Y' from Z', consecutive integers from the set of integers {1...n'} and {1...m'} so that there are n'+m' substituents, or H, R^{1(1')} (Y'=1) to R^{1(n')} (Y'=n') and R^{2(1')} (Z'=1) to R^{2(m')} (Z'=m');
wherein R¹⁽¹⁾ to R¹⁽ⁿ⁾ and R²⁽¹⁾ to R^{2(m)} are independently selected from H, and from substituents comprising 1-50 carbons, 0-20 O, S, Se, N and/or P heteroatoms, and optionally one or more halogens;
wherein R^{1(1')} to R^{1(n')} and R^{2(1')} to R^{2(m')} in formulae (Ib) are independently selected from H, and from substituents comprising 1-50 carbons, 0-20 O, S, Se, N and/or P heteroatoms, and optionally one or more halogens;
with the proviso that at least one substituent R^{1(Y)}, at least one substituent R^{2(Z)}, at least one of R¹⁽¹⁾ to R¹⁽ⁿ⁾, and at least one of R²⁽¹⁾ to R^{2(m)} is a substituent different from H;
with the proviso that, in formulae (Ib), at least one of R^{1(Y')}, at least one of R^{2(Z')}, at least one of R^{1(1')} to R^{1(n')}, and at least one of R^{2(1')} to R^{2(m')} is a substituent different from H; and,
R³ and R⁴ are substituents comprising each independently overall from 1-35 carbons, 0-20 O, S, Se, N and/or P heteroatoms, and optionally one or more halogens, wherein R³ and R⁴ may be connected to each other and form a substituted or unsubstituted ring or ring system bound to said atom A. If R³ and R⁴ are connected to form a ring or ring system, that ring or ring system may be aromatic or non-aromatic.

In other aspects, the invention provides compounds selected from the compounds of formulae (IIa), (IIb), (IIIa), (IIIb), (IVa), (IVb), (Va), (Vb), (VIa), (VIb), (VIIa), (VIIb) as defined in the appended claims and in the detailed description herein below.

In an aspect, the compounds of the invention are selected from:
5,5'-Bis[N,N-di(4-methoxyphenyl)aniline]-3,3'-dihexylsilylene-2,2'-bithiophene,
5,5'-Bis[N,N-di(4-methoxyphenyl)aniline]-3,3'-diphenylsilylene-2,2'-bithiophene, and
2,2',6,6'-Tetrakis-{N,N-di(4-methoxyphenyl)aniline}-4,4'-Spirobi[dithienosilole],

In an aspect, the invention provides the use of the compounds of the invention as hole transport materials (HTM).

In an aspect, the invention provides optoelectronic and/or electrochemical devices comprising a compound selected from the compounds of the invention. In an aspect, the invention provides optoelectronic and/or electrochemical devices comprising a hole transport layer, wherein said hole transport layer comprises or essentially consists of a compound selected from the compounds of the invention.

In an aspect, the invention provides solid state solar cells and/or OLEDS comprising the compound of the invention. In an aspect, the invention provides solid state solar cells comprises a hole transport layer, wherein said hole transport layer comprises a compound selected from the compounds of the invention.

In an aspect, the invention provides an organic-inorganic perovskite-based solar cell comprising the compound of the invention. In an aspect, the perovskite-based solar cell comprising a hole transport layer, wherein said hole transport layer comprises a compound selected from the compounds of the invention.

Further aspects and preferred embodiments of the invention are provided in the appended claims and are set forth in the detailed description herein below.

### Brief Description of the Drawings

**Figures 1** **A** and **1 B** shows schemes illustrating the synthesis of compounds PEH-1 and PEH-2 (compounds 1 and 2) according to an embodiment of the present invention.
**Figure 2** shows UV-Vis absorption spectra compounds PEH-1 and PEH-2 shown in Figure 1A.
**Figure 3** shows current-voltage curves of different solar cells containing either prior art Spiro-OMeTAD or compounds PEH-1 and PEH-2 as HTM in accordance with embodiments of the invention.
**Figure 4** is a graph showing maximum power output of solar cells as a function of time. The two traces show two devices using either prior art Spiro-OMeTAD or compound PEH-2 of an embodiment of the invention as HTM. The higher power output of the PEH-2-based device after about 50 hours shows the improved stability thanks to the use of the HTM of the invention.
**Figures 5** and **6** are schematic representations of embodiments of optoelectronic and/or electrochemical devices of the present invention.

### Detailed Description of the Preferred Embodiments

For the purpose of the present specification, the expression "comprise" and its various grammatical forms, such as "comprising", etc., is intended to mean "includes, amongst other". It is not intended to mean "consists only of".

The expression "at least one" is equivalent to "one or more".

The ring in formula (Ia) and the two rings in formula (Ib) represent each an aromatic ring or ring system optionally comprising one or more heteroatoms, wherein A is not counted in said optional one or more heteroatoms. Accordingly, whether A is Si or C, said aromatic ring or ring system optionally comprises one or more heteroatoms independently from and regardless of A. In a preferred embodiment, the ring heteroatoms are preferably selected independently from S, O and N. In an alternative embodiment, the ring in formula (Ia) and the two rings of formula (Ib) are free of any heteroatom, regardless of A, wherein A may be Si or C.

In a preferred embodiment, the ring in formula (Ia) and the two rings in formula (Ib) represent ring systems comprising one or more heteroatoms, preferably two heteroatoms, independently from and regardless of A. In a preferred embodiment, said ring system comprises two or more S (sulfur) heteroatoms.

Preferably, A is aromatically integrated in said aromatic ring or ring system A. Preferably, A is an sp³-hybridized Si or C atom.

Preferably, A represents a Si atom.

It is noted that the sum of n+m and n'+m', respectively, represents the maximum number of substituents that can be supported on the respective aromatic ring or ring system. In other words, the sums n+m and n'+m', respectively, represent the potential number of hydrogens that could be present on said aromatic ring or ring systems if there were no hydrogen substituted.

In preferred embodiments, n, n', m, m' are independently selected from integers of 1-5, preferably 1-4, more preferably 2-4, most preferably 2 or 4, in particular 2. Sums of n+m or n'+m', respectively, are thus preferably integers of 2-10, preferably 4-8, most preferably 4.

Preferably, said R^{1(Y)} and R^{2(Z)}, in other words, said R¹⁽¹⁾ to R¹⁽ⁿ⁾ and R²⁽¹⁾ to R^{2(m)} in formula (Ia) and (Ib), and said R^{1(Y')} and R^{2(Z')}, in other words, said R^{1(1')} to R^{1(n')} and R^{2(1')} to R^{2(m')} in formulae (Ib), are independently selected from H (hydrogen atoms), and from substituents comprising 1-50 carbons, 0-20 O, S, Se, N and/or P heteroatoms, and one or more halogens, preferably substituents comprising from 5-35 carbons, 1-10 O, S, Se, and/or N heteroatoms, and one or more halogens, more preferably 10-30 carbons and 1-5 O, S, Se, and/or N heteroatoms and one or more halogens, and most preferably 15-25 carbons and 2-5 O, S, and/or N heteroatoms and one or more halogens. Preferably, said substituents comprising 1-50 carbons, 0-20 O, S, Se, N and/or P heteroatoms and one or more halogens are identical.

In accordance with the invention, at least one of R^{1(Y)} and at least one of R^{2(Z)} is a substituent different from H. Furthermore, at least one of R^{1(Y')}, at least one of R^{2(Z')} is a substituent different from H. Furthermore, with respect to formula (Ib), at least one of R^{1(Y')} and at least one of R^{2(Z')} is a substituent different from H. Preferably, said substituents R^{1(Y)} and R^{2(Z)} that are different from H are identical. Preferably said substituents R^{1(Y')} and R^{2(Z')} that are different from H are identical. Preferably, R^{1(Y)}, R^{2(Z)}, R^{1(Y')}, R^{2(Z')} that are different from H are identical.

R^{1(Y)}, R^{2(Z)}, R¹⁽¹⁾, R¹⁽ⁿ⁾, R²⁽¹⁾ to R^{2(m)}, R^{1(Y')}, R^{2(Z')}, R^{1(1')} to R^{1(n')} and R^{2(1')} to R^{2(m')} may contain halogens if they are different from H, but they may not be halogen.

Accordingly, the aromatic ring or ring system of formula (Ia) carries at least two substituents that are different from H and each of the two the aromatic rings or ring systems of formula (Ib) carries at least two substituents that are different from H.

The two aromatic rings or ring systems of formula (Ib) are connected at A.

As becomes apparent, at least one of R²⁽¹⁾ to R^{2(m)} and at least one of R²⁽¹⁾ to R^{2(m)} is a substituent selected from said substituents comprising 1-50 carbons and 0-20 O, S, Se, N and/or P heteroatoms and one or more halogens and the preferred embodiments as described above and as further defined elsewhere in this specification. In addition, with respect to the compound of formula (Ib), at least one of R^{1(1')} to R^{1(n')}, and at least one of R^{2(1')} to R^{2(m')} is a substituent different from H and different from just halogen and thus a substituent selected from said substituents described above and elsewhere in this specification.

In a preferred embodiment, said substituent comprising 1-50 carbons, 0-20 O, S, Se, N and/or P heteroatoms and optionally one or more halogens or preferred embodiments is a selected from substituents of formula (1) below, from alkyl, alkylthio and alkoxyl; 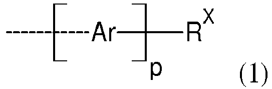 wherein the dotted line represents a covalent single bond by which the substituent of formula (1) is connected to the aromatic ring or ring system of formula (Ia) or (Ib),
p is 0 or selected from an integer of 1-3 (1, 2 or 3); and,
R^{X} is selected from -NR₁R₂, H, -O-R₁, -S-R₁, substituted and unsubstituted aryl, heteroaryl, alkyl, alkenyl and alkynyl; preferably R^{X} is -NR₁R₂;
wherein R₁ and R₂ are independently selected from substituted or unsubstituted aryl, heteroaryl, alkyl, alkenyl, and alkynyl, wherein, if said aryl, heteroaryls, alkyl, alkenyl, and alkynyl is substituted, substituents are selected from alkoxyl, alkylthio, phenoxyl, alkyl and halogen;
Ar is an monocyclic or bicyclic aromatic moiety, which comprises 0, 1 or 2 S, O and/or N heteroatoms and which may carry other substituents (other than H) in addition to R^{X};
wherein any aryl, heteroaryl, alkyl, alkenyl, alkynyl and phenoxyl may be partially or totally halogenated and any alkoxyl and alkylthio may be partially halogenated. Substituents such as -NR₁R₂, -O-R₁, -S-R₁, (including alkoxyl and alkylthio) may be partially halogenated as set forth elsewhere in this specification.

It is noted that in substituent (1), R^{X} is H only if p is ≥ 1.

Preferably, in said substituent of formula (1), R^{X} is selected from -NR₁R₂, and R₁ and R₂ are substituted or unsubstituted aryl or heteroaryl, preferably phenyl, and said substituents, if said aryl or phenyl is substituted, are selected from alkoxyl, alkylthio, alkyl and halogen, preferably C1-C6 alkoxyl, alkylthio or alkyl, more preferably C1-C3 alkoxyl or alkylthio. Preferably, p is 1. Preferably, Ar is a benzene moiety. R₁ and R₂ may be partially halogenated.

Preferably, said compound of formula (Ia) comprises two identical substituents of formula (1) and said compound of formula (Ib) comprises four identical substituents of formula (1).

R³ and R⁴ are organic substituents or residues comprising each independently overall from 1-35 carbons, 0-20 O, S, Se, N and/or P heteroatoms and optionally one or more halogens, wherein R³ and R⁴ may be connected to each other and form a substituted or unsubstituted ring or ring system bound to said atom A. The ring or ring system based on R³ and R⁴ may be aromatic. If R³ and R⁴ are connected to each other, a compound of formula (Ib) may be obtained. Preferably, R³ and R⁴ are not connected to each other.

In a preferred embodiment, R³ and R⁴ substituted or unsubstituted aliphatic or aromatic substituents comprising each independently overall from 1-35 carbons, 0-20 O, S, Se, N and/or P heteroatoms and optionally one or more halogens, wherein R³ and R⁴ may be connected to each other and form a substituted or unsubstituted aromatic ring or ring system bound to said atom A. Preferably, R³ and R⁴ are not connected to each other.

In a preferred embodiment, R³ and R⁴ are not connected to each other and comprise each independently overall 1-20 carbons, 0-15 O, S, Se, and/or N heteroatoms and optionally one or more halogens, more preferably 1-15 carbons, and 0-10 O, S, and/or N heteroatoms and optionally one or more halogens, and most preferably 1-10 carbons and 0-5 S, O and/or N heteroatoms and optionally one or more halogens.

In an embodiment, R³ and R⁴ are not connected to each other and are selected independently from unsubstituted or substituted or aryls, alkyls, alkenyls, alkynyls and heteroaryls. Optional substituents of said aryls, alkyls, alkenyls, alkynyls and heteroaryls may be selected from alkyl, alkoxyl, alkylthio, aryl, aroxyl, arylthio, and halogen, wherein said alkyl, alkoxyl, alkylthio, aryl, aroxyl, and arylthio substituent may be partially or, in case of alkyl and aryl, totally halogenated.

In a preferred embodiment, R³ and R⁴ are identical and not connected to each other.

In a preferred embodiment, R³ and R⁴ are selected from unsubstituted or substituted or aryls, heteroaryls, alkenyls and alkyls. Substituents are preferably selected from alkyl, alkoxyl, thioalkyl, phenyl and halogen, wherein said alkyl and phenyl may be totally halogenated and said alkyxyl or thioalkyl may be partially halogenated. More preferably R³ and R⁴ are selected from substituted and unsubstituted aryls and alkyls. Preferably, R³ and R⁴ comprising each overall 1-15 carbons, 0-5 O, S, and/or N heteroatoms and optionally one or more halogens.

In a most preferred embodiment of the compounds of formulae (Ia) and (Ib), A in formula (Ia) is selected from Si and C and, in formula (Ib) is Si; preferably A is Si in both, formula (Ia) and (Ib); each ring systems has at least two substituents of formula (1), in which p is 0 or 1, preferably 1; Ar is a monocyclic aryl or heteroaryl moiety; R^{X} is NR₁R₂; R₁ and R₂ are substituted or unsubstituted aryl or heteroaryl, and substituents of said aryl or heteroaryl, if present, are selected from C1-C6, preferably C1-C3 alkoxyl, alkylthio and alkyl, wherein said alkoxyl, alkylthio and alkyl may be totally or partially halogenated; and R³ and R⁴ in formula (Ia) are selected from unsubstituted and substituted aryls, heteroaryls, alkenyls and alkyls, R³ and R⁴ comprising each (including optional substituents) 1-20 carbons, 0-10 O, S, Se and/or N heteroatoms, and optionally one or more halogens; wherein optional substituents of said aryls, heteroaryls, alkenyls and alkyls are selected from alkyl, phenyl, alkoxyl, alkylthio, and halogen, which alkyl, alkoxyl, and alkylthio may be partially halogenated and wherein said alkyl and phenyl may be totally halogenated. Preferably, R³ and R⁴ are selected from unsubstituted or substituted or aryls, heteroaryls and alkyls, wherein substituents of said aryls, heteroaryls and alkyls, if present, may be selected from C1-C6 alkyls, C1-C6 alkoxyls, and C1-C6 alkylthio, wherein said C1-C6 alkyls may be partially or totally halogenated and said C1-C6 alkoxyls and alkylthio may be partially halogenated.

In a preferred embodiment, said compound is a compound selected from the compounds of formula (IIa) and (IIb): 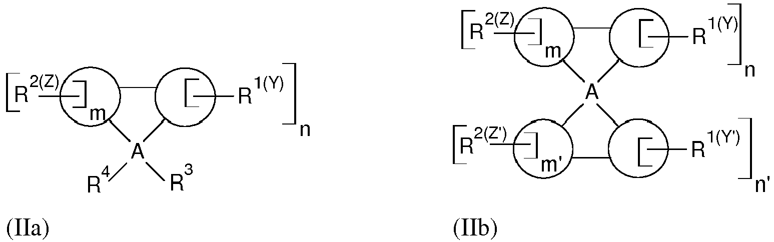 wherein the two rings carrying R^{1(Y)} and R^{2(Z)}, respectively, are connected to each other thereby forming an aromatic ring system containing A, wherein the same applies to the two rings carrying R^{1(Y')} and R^{2(Z')} in formula (IIb); A is connected to each of said two rings so as to be part of a central ring fused to each of said two rings; and, wherein n, m, R^{1(Y)} and R^{2(Z)} R³ and R⁴, and n', m', R^{1(Y')} and R^{2(Z')}, respectively, are as defined elsewhere in this specification, in particular as defined hereinabove, in the summary of the invention and/or above with respect to embodiments of the compounds of formulae (Ia) and (Ib).

As mentioned with respect to embodiments of the compounds of formulae (Ia) and (Ib), A is preferably aromatically integrated in said aromatic ring system and is preferably sp³-hybridized.

It becomes apparent that the compounds of formulae (Ib) and (IIb) are spiro-compounds, in which two rings or ring systems are connected via the atom A.

Compared to the embodiments of formulae (Ia) and (Ib), the embodiment of formulae (IIa) and (IIb) specifies that A is part of an aromatic ring system, which comprises a central ring containing A and two lateral rings. Said ring system is thus a three-membered ring system. For example, in formula (IIa), there is a first (e.g. right) lateral ring carrying R^{1(Y)} and a second (e.g. left) lateral ring carrying R^{2(Z)}. In formula (IIb), there are two three-membered ring systems linked via A, each ring system having two lateral rings carrying, altogether R^{1(Y)}, R^{2(Z)}, R^{1(Y')} and R^{2(Z')} as shown in formula (IIb).

In a preferred embodiment, A in the compounds of formula (IIa) is selected from Si and C and in formula (IIb) is Si. More preferably A is Si in formulae (IIa) and in formula (IIb).

A most preferred embodiment with respect to A, of R^{1(Y)}, R^{2(Z)}, R^{1(Y')} and R^{2(Z')}, R³ and R⁴ in formulae (IIa) and (IIb) is exactly as depicted with respect to the most preferred embodiment of formulae (Ia) and (Ib).

In a preferred embodiment, the compound of the invention is selected from compounds of formulae (IIIa), (IIIb), (IVa) and (IVb): 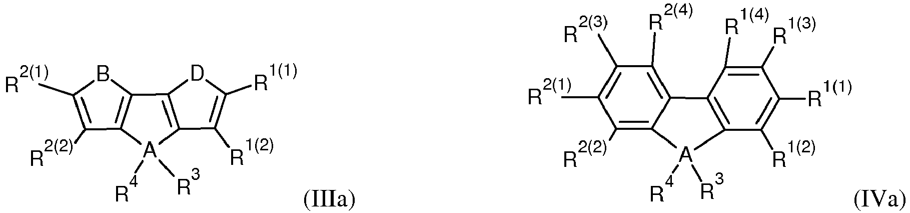 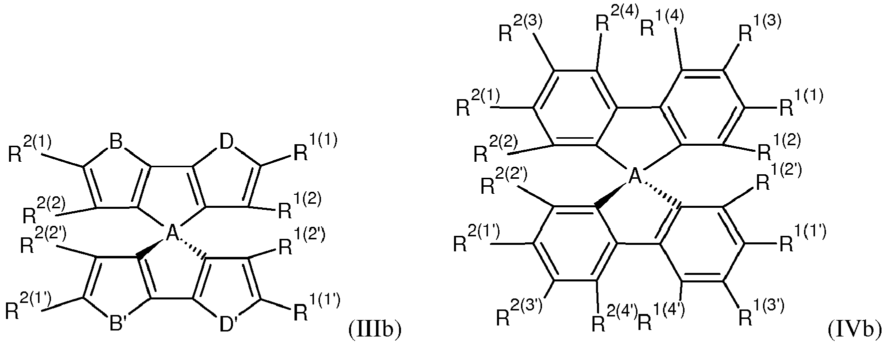 wherein R³ and R⁴ are as defined as specified elsewhere in this specification, in particular with respect to the embodiments of formulae (Ia) and (Ib);
A in formulae (IIIa), and (IIIb) is selected from Si and C; and A in formulae (IVa) and (IVb) is Si;
R¹⁽¹⁾-R¹⁽²⁾ and R²⁽¹⁾-R²⁽²⁾ in formulae (IIIa) and (IIIb); R¹⁽¹⁾-R¹⁽⁴⁾ and R²⁽¹⁾-R²⁽⁴⁾ in formulae (IVa) and (IVb), are defined independently as R¹⁽¹⁾ to R¹⁽ⁿ⁾ and R²⁽¹⁾ to R^{2(m)} as specified elsewhere in this specification, in particular with respect to the embodiments of formulae (Ia) and (Ib) above;
R^{1(1')}-R^{1(2')} and R^{2(1')}-R^{2(2')} in formulae (IIIb); R^{1(1')}-R^{1(4')} and R^{2(1')}-R^{2(4')} in formulae (IVb), are defined as R^{1(1')} to R^{1(n')} and R^{2(1')} to R^{2(m')} as specified elsewhere in this specification, in particular with respect to the embodiments of formulae (Ia) and (Ib) above;
B, D, B' and D' are selected, independently, from O, S, and from N-R¹⁽³⁾ (for D), N-R^{1(3')} (for D'), N-R²⁽³⁾ (for B), and N-R^{2(3')} (for B'), respectively.

As specified elsewhere, at least one of one of R¹⁽¹⁾-R¹⁽²⁾ in formulae (IIIa) and (IIIb), at least one of one of R²⁽¹⁾-R²⁽²⁾ in formulae (IIIa) and (IIIb), at least one of one of R^{1(1')}-R^{1(2')} in formula (IIIb), at least one of one of R^{2(1')}-R^{2(2')} in formula (IIIb), at least one of R¹⁽¹⁾-R¹⁽⁴⁾ in formulae (IVa) and (IVb), at least one of R²⁽¹⁾-R²⁽⁴⁾ in formulae (IVa) and (IVb), at least one of one of R^{1(1')}-R^{1(4')} in formula (IVb) and at least one of R^{2(1')}-R^{2(4')} in formula (IVb) is other than (different from) H and as defined elsewhere in this specification, preferably selected from substituents of formula (1) as defined elsewhere in this specification, the remaining substituents being H.

Preferably, A is Si.

Preferably, B, D, B' and D', in as far as present, are selected from O and S, preferably they are all S.

In a preferred embodiment, R³ and R⁴ substituted or unsubstituted aliphatic or aromatic substituents comprising each independently overall from 1-35 carbons, 0-20 O, S, Se, N and/or P heteroatoms and optionally one or more halogens.

In an embodiment, R³ and R⁴ in formulae (IIa), (IIIa) and (IVa) are selected independently from unsubstituted or substituted or aryls, alkyls, alkenyls, alkynyls and heteroaryls. Optional substituents of said aryls, alkyls, alkenyls, alkynyls and heteroaryls may be selected from alkyl, phenyl alkoxyl, alkylthio, aryl, aroxyl, arylthio, and halogen. Preferably, R³ and R⁴ comprise each independently overall (including optional substituents) 1-20 carbons, 0-10 O, S, Se, and/or N heteroatoms and optionally one or more halogens, more preferably 1-15 carbons and 0-5 O,S, and/or N heteroatoms and optionally one or more halogens and most preferably 1-10 carbons, 0 heteroatoms other than optional halogens and optionally one or more halogens. Said alkyl, phenyl alkoxyl, alkylthio, aryl, aroxyl, arylthio may be partially or totally halogenated.

In a preferred embodiment, R³ and R⁴ are identical and not connected to each other.

In a preferred embodiment, R³ and R⁴ are selected from unsubstituted or substituted or aryls, heteroaryls, alkenyls and alkyls. More preferably R³ and R⁴ are selected from aryls and alkyls. Preferably, R³ and R⁴ comprise each 1-15 carbons, 0-5 O,S, Se and/or N heteroatoms and one or more halogens.

In a most preferred embodiment of the compounds of formulae (IIIa), (IIIb), (IVa) and (IVb); A in the compounds of formulae (IIIa) and (IIIb) is Si or C and in formulae (IVa) and (IVb) is Si; B, D, B', D' are selected, independently, from S and O,preferably all are S; R¹⁽¹⁾ and R²⁽¹⁾ in formula (IIIa), (IIIb), (IVa), (IVb), and R^{1(1')}, R^{2(1')} in formulae (IIIb) and (IVb) are identical substituents of formula (1) having overall from 5-35 carbons, O,S, Se, and/or N 1-10 heteroatoms and optionally one or more halogens, in which substituents of formula (1) p is 0 or 1, Ar (if p=1) is a monocyclic aryl or heteroaryl moiety, which may carry other substituents in addition to R^{X}; Optional other substituents of Ar other than H may be selected from C1-C6 aliphatic substituents, C1-C6 alkoxyl, C1-C6 alkylthio and from halogen; R^{X} is selected from NR₁R₂, R₁ and R₂ are substituted or unsubstituted aryl or heteroaryl, and optional substituents of said aryl or heteroaryl, if present, are selected from C1-C6, preferably C1-C3 alkoxyl, alkylthio and alkyl, wherein said alkoxyl, alkylthio and alkyl may be totally or partially halogenated; the other of R¹⁽¹⁾-R¹⁽⁴⁾, R²⁽¹⁾-R²⁽⁴⁾, R^{1(1')}-R^{1(4')}, and R^{2(1')}-R^{2(4')} in as far as present, are H; and R³ and R⁴ in formulae (IIIa) and (IVa) are selected from unsubstituted or substituted or aryls, heteroaryls, alkenyls and alkyls, R³ and R⁴ comprising each overall 1-20 carbons, 0-10 O,S, Se, and/or N heteroatoms and optionally one or more halogens, wherein optional substituents of said aryls, heteroaryls, alkenyls and alkyls are selected from alkyl, phenyl, alkoxyl, alkylthio, and halogen, which alkyl, phenyl, alkoxyl, and alkylthio may be partially halogenated and wherein said alkyl and phenyl may be totally halogenated. Preferably, R³ and R⁴ are selected from unsubstituted or substituted or aryls, heteroaryls and alkyls, wherein substituents of said aryls, heteroaryls and alkyls, if present, may be selected from C1-C6 alkyls, C1-C6 alkoxyls and C1-C6 alkylthio, wherein said C1-C6 alkyls may be partially or totally halogenated and said C1-C6 alkoxyls and alkylthio may be partially halogenated.

In a preferred embodiment of the compounds of the invention:
i) R^{1(Y)} and R^{2(Z)} in formulae (Ia), (Ib), (IIa), and (IIb);
ii) R¹⁽¹⁾ to R¹⁽ⁿ⁾ and R²⁽¹⁾ to R^{2(m)} in claim 1;
iii) R¹⁽¹⁾-R¹⁽²⁾, R²⁽¹⁾-R²⁽²⁾ and, if present R¹⁽³⁾ and R²⁽³⁾, in formulae (IIIa) and (IIIb);
iv) R¹⁽¹⁾-R¹⁽⁴⁾ and R²⁽¹⁾-R²⁽⁴⁾ in formulae (IVa) and (IVb);
v) R^{1(Y')} and R^{2(Z')} in formulae (Ib) and (IIb);
vi) R^{1(1')} to R^{1(n')} and R^{2(1')} to R^{2(m')} in claim 1;
vii) R^{1(1')}-R^{1(2')}, R^{2(1')}-R^{2(2')} and, if present, R^{1(3')} and R^{2(3')} in formulae (IIIb);
viii) R^{1(1')}-R^{1(4')}, and R^{2(1')}-R^{2(4')} in formulae (IVb);
   are, independently, selected from H, substituted or unsubstituted aryls, heteroaryls, alkyls, alkenyls, alkynyls, and from substituents of formulae -O-R₁, -S-R₁ and -NR₁R₂;
   with the proviso that in the compounds of formulae (IIIa) and (IIIb), R¹⁽³⁾ and R²⁽³⁾, if present, are not selected from -O-R₁, -S-R₁ and -NR₁R₂; and, with the proviso that in the compound of formulae (IIIb), R^{1(3')} and R^{2(3')}, if present, are not selected from -O-R₁, -S-R₁ and -NR₁R₂;
   with the proviso that:
   at least one of R^{1(Y)}, at least one of R^{2(Z)}, at least one of R^{1(Y')}, at least one of R^{2(Z')};
   at least one of R¹⁽¹⁾ to R¹⁽ⁿ⁾ at least one of R²⁽¹⁾ to R^{2(m)}, at least one of R^{1(1')} to R^{1(n')}, at least one of R^{2(1')} to R^{2(m')},
   at least one of R¹⁽¹⁾-R¹⁽²⁾ in formulae (IIIa) and (IIIb), at least one of R²⁽¹⁾-R²⁽²⁾ in formulae (IIIa) and (IIIb), at least one of R^{1(1')}-R^{1(2')} in formula (IIIb), at least one of R^{2('1)}-R^{2('2)} in formula (IIIb),
   at least one of R¹⁽¹⁾-R¹⁽⁴⁾ in formulae (IVa) and (IVb), at least one of R²⁽¹⁾-R²⁽⁴⁾ in formulae (IVa) and (IVb), at least one of R^{1(1')}-R^{1(4')}, in formula (IVb), and at least one of R^{2(1')}-R^{2(4')} in formula (IVb);
      is different from H;
      A) wherein substituents of said aryls, heteroaryls, alkyls, alkenyls, alkynyls, if present, are independently selected from -NR₁R₂, -O-R₁, -S-R₁, aryl, heteroryl, alkyl, alkenyls, and alkynyls;
      B) wherein R₁ and R₂ are independently selected from substituted or unsubstituted aryl, heteroaryl, alkyl, alkenyl, and alkynyl;
   wherein any aryl, alkyl heteroaryl, alkyl, alkenyl, and alkynyl may be partially or totally halogenated.

Preferably, if any one of said R₁ and R₂ under B) is substituted, such substituents are independently selected from alkoxyl, alkylthio, alkyl, phenoxyl, and phenylthio, which may be optionally partially halogenated and wherein said alkyl, phenoxyl and phenylthio may be totally halogenated, and wherein substituents of R₁ and R₂ may also be selected from halogens.

In a preferred embodiment, R₁ and R₂ each has independently overall (including optional further substituents) 1-20 carbons, 0-10 O,S, Se, and/or N heteroatoms and optionally one or more halogens, preferably, 1-15 carbons, 0-5 O,S, and/or N heteroatoms and optionally one or more halogens, more preferably have 4-10 carbons, 0-2 O,S, and/or N heteroatoms and optionally one or more halogens, for example 7 carbons and 1 O, and/or S heteroatoms.

Preferably, R₁ and R₂ are identical.

Halogens may be present on the aryl, heteroaryl, alkyl, alkenyl, and alkynyl substituents, if substituents i)-viii) are aryl, heteroaryl, alkyl, alkenyl, or alkynyl. Furthermore, halogens may also be present in the aryl, alkyl, heteroaryl, alkyl, alkenyl, and alkynyl as listed under A) and B).

In a most preferred embodiment, said at least one residue in each of i)-viii) that is different from H is a substituted aryl or heteroaryl, preferably phenyl and wherein substituents are selected from -NR₁R₂, wherein R₁ and R₂ are different or identical substituents selected from substituted or unsubstituted aryl and heteroaryls, preferably phenyl; and wherein substituents of said aryl or heteroaryls are selected from alkoxyl, alkylthio, alkyl and halogen, wherein said alkoxyl, alkylthio and alkyl may be totally or partially halogenated. In the context of this most preferred embodiment, R³ and R⁴ are preferably as defined as in the most preferred embodiment of formulae (Ia) and (Ib). In particular, R³ and R⁴ are preferably selected from unsubstituted and substituted aryls, heteroaryls, alkenyls and alkyls.

In a preferred embodiment of the compounds of the invention, in particular of the compounds of formulae (Ia), (Ib), (IIa), (IIb), (IIIa), (IIIb), (IVa), and (IVb), one or more of said at least one substituents that is different from H is selected from substituents of formula (1) below: 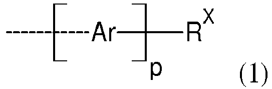 wherein the dotted line represents a covalent single bond by which the substituent of formula (1) is connected to the aromatic ring or ring system,
p is 0 or an integer of 1-3, preferably 0, 1 or 2, more preferably 0 or 1 and most preferably 1; and,
R^{X} is selected from -NR₁R₂, H, -O-R₁, -S-R₁, substituted and unsubstituted aryl, heteroaryl, alkyl, alkenyl, and alkynyl, preferably R^{X} is selected from -NR₁R₂, -O-R₁, and -S-R₁, more preferably R^{X} is -NR₁R₂;
wherein R₁ and R₂ are independently selected from substituted or unsubstituted aryl, heteroaryl, alkyl, alkenyl, and alkynyl, preferably R₁ and R₂ are independently selected from substituted or unsubstituted aryl and heteroaryls;
wherein, if said aryl, heteroaryls, alkyl, alkenyl, and alkynyl (of R^{X} and/or of R₁ and R₂) is substituted, substituents are selected from alkoxyl, alkylthio, phenoxyl, alkyl and halogen; Ar is a monocyclic, bicyclic or polycyclic aromatic moiety, which comprises 0, 1 or 2 S, O and/or N heteroatoms, wherein Ar may comprise other substituents (other than H) in addition to RX,
wherein any aryl, heteroryl, alkyl, alkenyl, alkynyl and phenoxyl may be partially or totally halogenated and any alkoxyl and alkylthio may be partially halogenated.

It is noted that in substituent (1), R^{X} is H only if p is ≥ 1.

In a preferred embodiment, R^{X} is not H. More preferably, R^{X} is -NR₁R₂.

If p > 1, each Ar may be identical or different from the other or others Ar, respectively, in the same substituent of formula (1).

In a preferred embodiment of the substituent of formula (1), p is 0 or 1, R^{X} is selected from - NR₁R₂, substituted and unsubstituted aryl and substituted and unsubstituted heteroaryl; R₁ and R₂ are independently selected from substituted or unsubstituted aryl and substituted and unsubstituted heteroaryls; wherein (optional) substituents of said substituted and unsubstituted aryl or heteroaryls (as R^{X} or as R₁, R₂) are selected from alkoxyl, alkylthio, and alkyl; and Ar is a monocyclic aromatic moiety, which comprises 0, 1 or 2 S, O and/or N heteroatoms. Preferably, Ar does not comprise any further substituent (other than H) in addition to R^{X}.

In most preferred embodiment of the substituent of formula (1), p is 1, R^{X} is -NR₁R₂; R₁ and R₂ are independently selected from substituted or unsubstituted aryl, preferably phenyl, and substituted and unsubstituted heteroaryls; wherein (optional) substituents of said substituted and unsubstituted aryl or heteroaryls (as R_{1,} R₂) are selected from alkoxyl, alkylthio, alkyl and halogen (preferably C1-C6 alkoxyl, alkylthio or alkyl), wherein said alkoxyl, alkylthio and alkyl substituent may be partially or totally halogenated; and Ar is a monocyclic aromatic moiety, which comprises 0 or 1 S, O or N heteroatom. Preferably, Ar does not comprise any further substituent (other than H) in addition to R^{X}.

In an embodiment, the compound of the invention is a compound selected of formulae (Va) and (Vb): 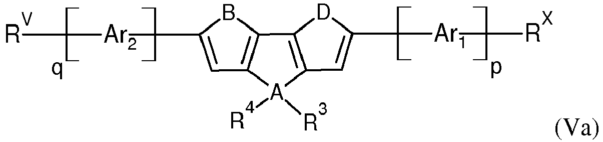 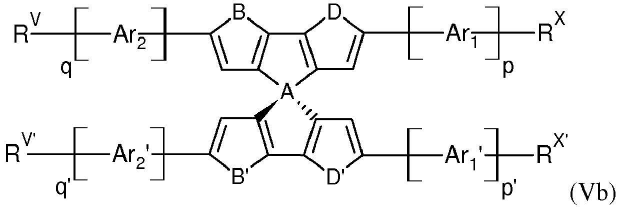 wherein R³ and R⁴ are as defined elsewhere in this specification, in particularwith respect to the embodiments of formulae (Ia) and (Ib);
A is selected from Si and C, preferably Si;
B, D, B' and D' are selected, independently, from O, S, and from N-R¹⁽³⁾ (for D), N-R^{1(3')} (for D'), N-R²⁽³⁾ (for B), and N-R^{2(3')} (for B'), respectively, as defined elsewhere in this specification, in particular with respect to the embodiments of formulae (IIIa) through (IVb) above;
p, q, p', q' are independently selected from integers of 1-3 and from 0; preferably from 0, 1 and 2, more preferably 0 and 1 and most preferably 1;
R^{X}, R^{V}, R^{X'} and R^{V'}, are also present if any one of p or q or p' or q', respectively, is 0, and are selected independently from -NR₁R₂, H, -O-R₁, -S-R₁, substituted and unsubstituted aryl, heteroaryl, alkyl, alkenyl and alkynyl;
wherein R₁ and R₂ are independently selected from substituted or unsubstituted aryl, heteroaryl, alkyl, alkenyl, and alkynyl;
wherein, if any one of said aryl, heteroaryl, alkyl, alkenyl, and alkynyl of R^{X}, R^{V}, R^{X'}, R^{V'} and of R₁ and R₂ is substituted, substituents are selected from alkoxyl, alkylthio, alkyl and halogen, and wherein said alkoxyl, alkylthio and alkyl may be partially halogenated and said alkyl may be totally halogenated;
Ar₁, Ar₂, Ar₁' and Ar₂' are selected from monocyclic, bicyclic and polycyclic aromatic moieties, which comprise 0, 1 or 2 S, O and/or N heteroatoms and which may comprise other substituents (other than H) in addition to R^{X}, R^{V}, R^{X'} and R^{V'}, respectively;
wherein if p and/or q > 1, each Ar₁ and each Ar₂, may be identical or different from the other or others Ar₁ or Ar₂, respectively, and, if p' and/or q' > 1, each Ar₁' and each Ar₂', may be identical or different from the other or others Ar₁' or A₂', respectively.

It is noted that in formulae (Va) and (Vb) any one of R^{X}, R^{V}, R^{X'} and R^{V'} is H only if p, q, p', and q' of the respective substituent is ≥ 1. Preferably, R^{X}, R^{V}, R^{X'} and R^{V'} are not H,

Exemplary aryl moieties Ar, Ar₁, Ar₂, Ar₁' and Ar₂', for example in the structures of formulae (1), (Va), (Vb), may be selected by the skilled person. For the purpose of illustration, formulae (10)-(27) below show a few aryl moieties from which Ar, Ar₁, Ar₂, Ar₁' and Ar₂' may be selected.

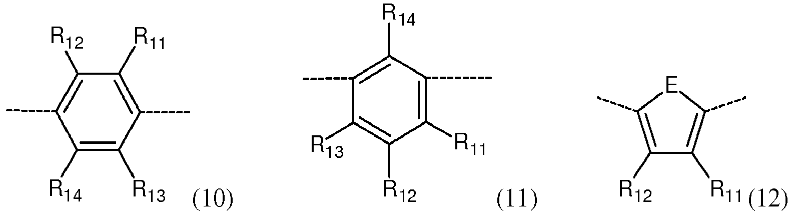

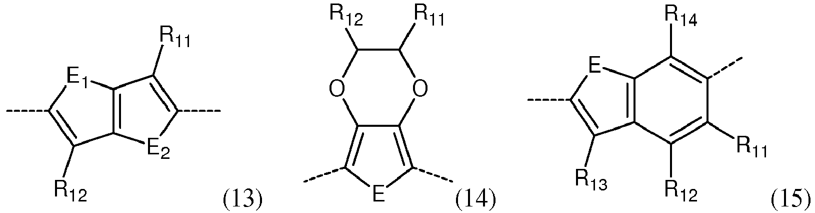

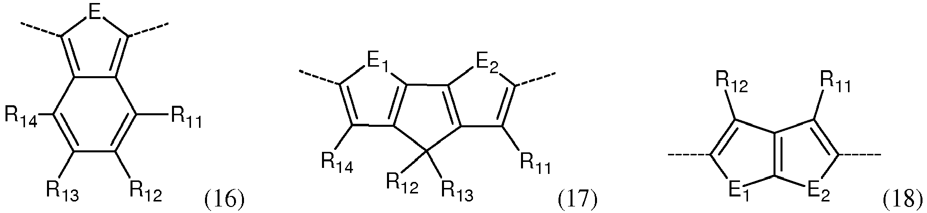

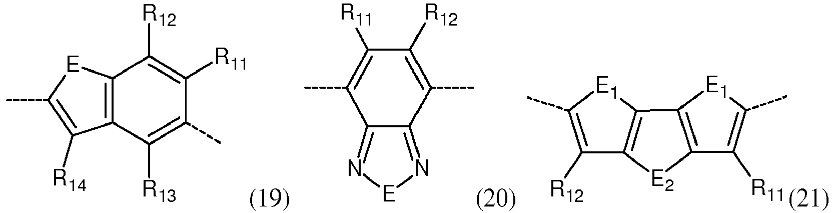

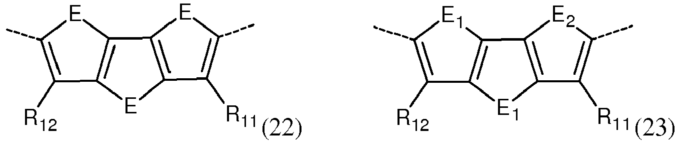

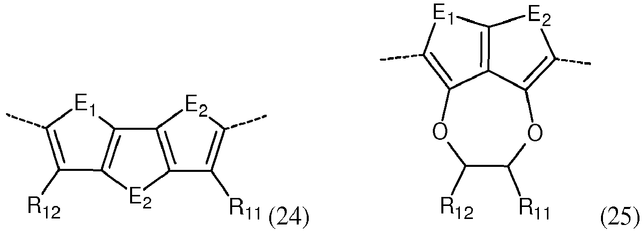

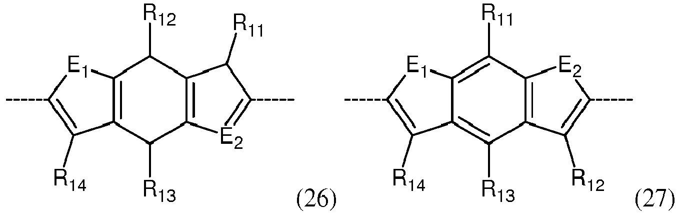

In the moieties of formulae (10)-(27), the dotted lines represent the carbon-carbon single bonds by way of which the aryl or heteroaryls moiety is integrated in the compound of the invention or in substituent (1). For example if an aryl moiety of (10)-(27) is part in the substituent of formula (1), the left dotted bond represents the bond by which the aryl moiety is connected to the aromatic ring or ring system containing A or to a preceding aryl moiety in case p is 2 or 3, and the right dotted bond represents the bond by which the aryl moiety is connected to a subsequent aryl moiety or to R^{X}, R^{V}, R^{X'} and R^{V'} (see formulae (1), (Va) and (Vb)).

E, E₁ and E₂ are independently selected from O, S and Se atoms, preferably from O and S, with the proviso that in a given moiety E is always the same atom, E₁ is always the same atom and E₂ is always the same atom, and, if there are E₁ and E₂ in the same moiety, E₁ is an atom that is different from E₂. For example, if in a particular moiety E₁ is oxygen, E₂ can be selenium or S, preferably S. Preferably, E is selected from S and O, E₁ is oxygen and is E₂ sulfur, or E₂ is oxygen and is E₁ sulfur.

R₁₁-R₁₄ are independently selected from H, C1-C6 alkyl, C1-C6 alkoxyl, C1-C6 alkylthio (-S-alkyl), -C≡N, and from halogen.

Aryl moieties (10)-(13), (18), (21)-(24) are preferred aryl moieties, for example for Ar, Ar₁, Ar₂, Ar₁' and Ar₂'. Aryl moieties (10)-(13) are more preferred, and (10) is the most preferred.

In a preferred embodiment, R^{X}, R^{V}, R^{X'} and R^{V'}, are not H.

In a preferred embodiment of formulae (Va) and (Vb) are selected independently from unsubstituted or substituted or aryls, alkyls, alkenyls, alkynyls and heteroaryls. Optional substituents of said aryls, alkyls, alkenyls, alkynyls and heteroaryls may be selected from alkyl, alkoxyl, alkylthio, aryl, aroxyl, arylthio, and halogen, wherein said alkyl, alkoxyl, alkylthio, aryl, aroxyl, and arylthio substituent may be partially or, in case of alkyl and aryl, totally halogenated.

In a preferred embodiment of the compound of formulae (Va) and (Vb), A is Si or C, preferably Si; B, D, B' and D' are S; p, q, p', q' are all identical and are either 0 or 1; Ar, Ar₁, Ar₂, Ar₁' and Ar₂', if p, q, p', q' are 1, are all the same and are selected from aryl moieties (10)-(13), (18), (21)-(24); R^{X}, R^{V}, R^{X'} and R^{V'} are all identical and are selected from - NR₁R₂, -O-R₁, -S-R₁, from substituted and unsubstituted aryl, alkyl, alkoxyl, and thioalkyl; R₁ and R₂ are identical and are selected from substituted or unsubstituted aryl or heteroaryl. Preferably, R^{X}, R^{V}, R^{X'} and R^{V'} are selected from -NR₁R₂; and R³ and R⁴ in formulae (IIIa) and (IVa) are selected from unsubstituted and substituted aryls, heteroaryls alkenyls and alkyls, R³ and R⁴ comprising each overall 1-20 carbons, 0-15 O, S, Se, and/or N heteroatoms and optionally one or more halogens. Preferably, substituents of any one of said substituted aryl, heteroaryl, alkenyl and alkyl, may be selected from alkyl, alkoxyl, thioalkyl and halogen, which alkyl, alkoxyl, and thioalkyl substituent may be totally or partially halogenated as specified elsewhere in this specification.

In a most preferred embodiment of the compound of formulae (Va) and (Vb), A is Si; B, D, B' and D' are S; p, q, p', q' are all 1; Ar, Ar₁, Ar₂, Ar₁' and Ar₂' are selected from aryl moieties (10)-(13) and (18); R^{X}, R^{V}, R^{X'} and R^{V'} are all identical and are selected from -NR₁R₂; R₁ and R₂ are identical and are selected from substituted or unsubstituted aryl or heteroaryl; and R³ and R⁴ in formulae (IIIa) and (IVa) are selected from unsubstituted or substituted or aryls, heteroaryls, alkenyls and alkyls, preferably unsubstituted or substituted or phenyl. R³ andR⁴ preferably comprise each overall 1-20 carbons, and 0-15 O, S, Se, and/or N heteroatoms and optionally one or more halogens. Preferably, substituents of any one of said substituted aryl, heteroaryl, alkenyls and alkyl may be selected from alkyl, alkoxyl, thioalkyl and halogen, which alkyl, alkoxyl, thioalkyl may be totally or partially halogenated. Preferably, Ar, Ar₁, Ar₂, Ar₁' and Ar₂' are selected from monocyclic moieties (10)-(12).

In a preferred embodiment, the compound of the invention is a compound selected from compounds of formulae (VIa) and (VIb): 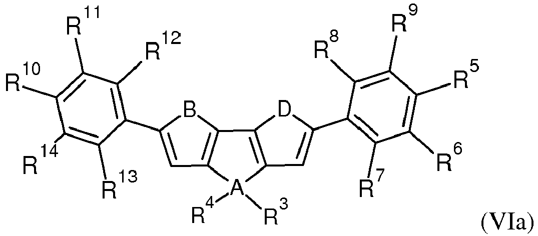 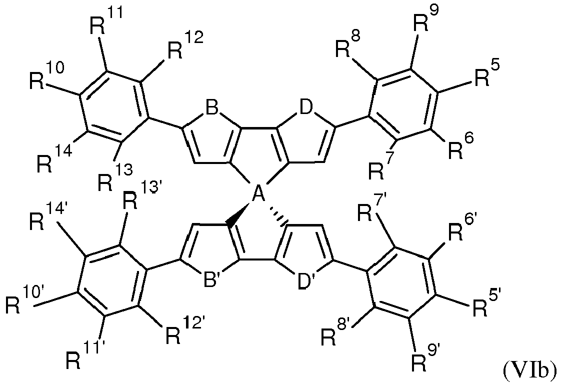 wherein A is selected from Si and C, preferably Si;
R³ andR⁴ are as defined in described elsewhere in this specification, for example as defined in the summary of invention and with respect to the embodiments of formulae (Ia) and (Ib) above;
B, D, B' and D' are selected, independently, from O, S, and from N-R¹⁽³⁾ (for D), N-R^{1(3')} (for D'), N-R²⁽³⁾ (for B), and N-R^{2(3')} (for B'), respectively, as defined elsewhere in this specification, in particular with respect to the embodiments of formulae (IIIa) through (IVb)above;
A) wherein any one of the substituents R⁵-R¹⁴ and R^{5'}-R^{14'} is independently selected from H, -NR₁R₂, -O-R₁, -S-R₁, substituted and unsubstituted aryl, heteroaryl, alkyl, alkenyl, alkynyl and halogen; with the proviso that:
in formulae (VIa) and (VIb), at least one of R⁵-R⁸ and at least one of R¹⁰-R¹⁴ is different from H and halogen; and, in formula (VIb), at least one of R^{5'}-R^{8'} and at least one R^{10'}-R^{14'} is different from H and halogen;
   a) wherein optional substituents of said aryl, heteroryl, alkyl, alkenyl, alkynyl under A) are selected from substituents of formulae -O-R_{1,} -S-R₁, -NR₁R₂, alkyl and halogen;
   b) wherein R₁ and R₂ are independently selected from substituted or unsubstituted aryl, heteroaryl, alkyl, alkenyl, and alkynyl;
      (i) wherein, if any one of said aryl, heteroaryl alkyl, alkenyl, and alkynyl, under b) is substituted, such substituents are independently selected from alkoxyl, alkylthio, alkyl, phenoxyl and halogen, wherein said alkoxyl and alkylthio may be partially halogenated and said alkyl and phenoxyl may be partially or totally halogenated;
wherein any one of said aryl, heteroaryl, alkyl, alkenyl, alkynyl under a) and b) may be totally or partially halogenated.

In a preferred embodiment of the compounds of formulae (VIa) and (VIb), A is selected from Si or C; B, D, B', and D' are selected from S and O, preferably all identical, more preferably all S; R⁵-R¹⁴ and R^{5'}-R^{14'} are independently selected from H, -NR₁R₂, -O-R₁, halogen and, substituted and unsubstituted aryl and heteroaryl; wherein again at least one of R⁵-R⁸ and at least one of R¹⁰-R¹⁴ is different from H and from halogen; and, in formula (VIb), at least one of R^{5'}-R^{8'} and at least one R^{10'}-R^{14'} is different from H and from halogen; R₁ and R₂ are independently selected from substituted or unsubstituted aryl, heteroaryl, and alkyl; wherein substituents of said substituted aryls and heteroaryls and alkyl (including optional substituents of R⁵-R¹⁴ and R^{5'}-R^{14'} and of R₁ and R₂) are preferably selected from alkoxyl, alkylthio and alkyl; and R³ and R⁴ in formula (VIa) are identical and are selected from unsubstituted or substituted or aryls, heteroaryls, alkenyls and alkyls, R³ and R⁴ comprising each overall 1-20 carbons, 0-15 O, S, Se, and/or N heteroatoms and optionally one or more halogens. Preferably, R³ and R⁴ are unsubstituted or substituted phenyl.

In a most preferred embodiment of the compound of formulae (VIa) and (VIb), A is Si; B, D, B', and D' are all S; R⁶, R⁷, R⁸, R⁹, R¹¹, R¹², R¹³, R¹⁴, R^{6'}, R^{7'}, R^{8'}, R^{9'}, R^{11'}, R^{12'}, R^{13'}, R^{14'}, are all H; and R⁵, R¹⁰, R^{5'}, and R^{10'}, are selected from -NR₁R₂, -O-R₁, and, substituted and unsubstituted aryl; R₁ and R₂ are independently selected from substituted or unsubstituted aryl, preferably phenyl and heteroaryl; wherein optional substituents of said aryl, heteroaryl, and alkyl (including substituents of substituted aryl of R⁵, R¹⁰, R^{5'}, and R^{10'}) are selected from alkoxyl, alkylthio, alkyl and halogen, wherein said alkoxyl, alkylthio and alkyl may be totally or partially halogenated; R³ and R⁴ in formula (VIa) identical and are selected from unsubstituted or substituted or aryls, heteroaryls, alkenyls and alkyls, which may be substituted, for example by halogen, alkyl, alkoxyl and thioalkyl, wherein said alkyl, alkoxyl and thioalkyl may be totally or partially halogenated.

In a preferred embodiment, the compound of the invention is a compound selected from compounds of formulae (VIIa) and (VIIb): 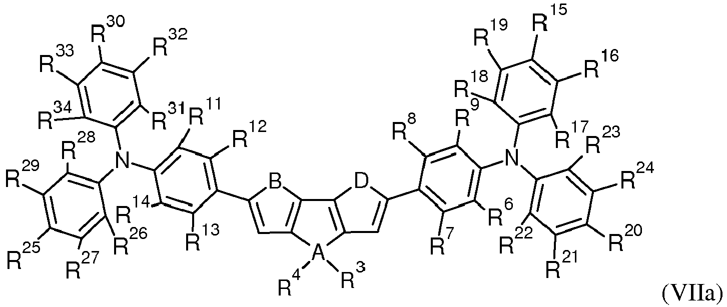 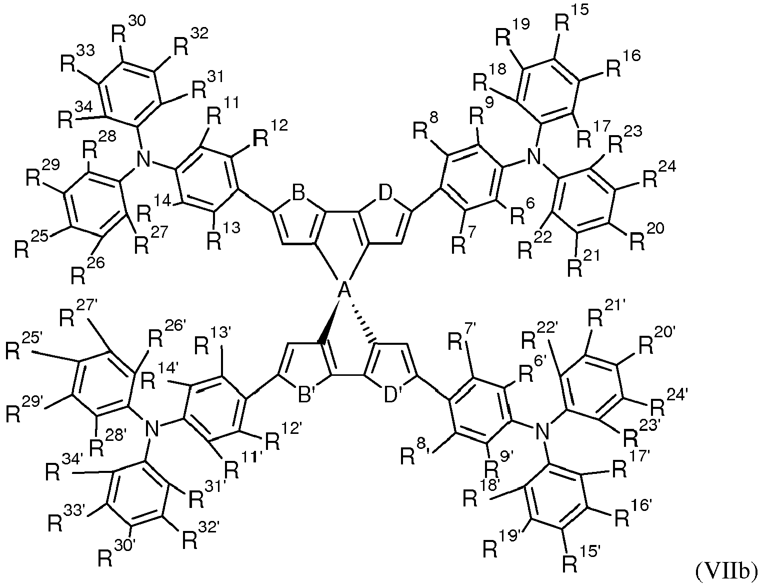 wherein A is selected from Si and C, preferably Si;
R³ and R⁴ are as defined in described elsewhere in this specification, for example as defined in the summary of invention and with respect to the embodiments of formulae (Ia) and (Ib) above;
B, D, B' and D' are selected, independently, from O, S, and from N-R¹⁽³⁾ (for D), N-R^{1(3')} (for D'), N-R²⁽³⁾ (for B), and N-R^{2(3')} (for B'), respectively, as defined elsewhere in this specification, in particular with respect to the embodiments of formulae (IIIa) through (IVb)above;
wherein any one of R⁶-R³⁴ in formulae (VIIa) and (VIIb), and any one R^{6'}-R^{34'} in formula (VIIb), respectively, is independently selected from H, alkoxyl, alkylthio, alkyl, phenoxyl and halogen, and wherein, if any one of R⁶-R³⁴ that is alkoxyl or alkylthio and that is other than methoxyl and methylthio, may be partially halogenated, and any one of R⁶-R³⁴ that is alkyl may be partially or totally halogenated.

In a preferred embodiment of the compound of formulae (VIIa) and (VIIb) R¹⁵, R²⁰, R²⁵, and R³⁰ are independently selected from alkoxyl, alkylthio or alkyl, the other of R⁶-R³⁴ being H or halogen, and wherein in formula (VIIb) R^{15'}, R^{20'}, R^{25'}, R^{30'} are selected from alkoxyl, alkylthio or alkyl, the other of R^{6'}-R^{34'} being H or halogen, wherein said alkoxyl and alkylthio, if it other than methoxyl and methylthio, may be partially halogenated, and wherein said alkyl may be partially or totally halogenated.

Preferably, R¹⁵, R²⁰, R²⁵, and R³⁰ in formulae (VIIa) and (VIIb) and R^{15'}, R^{20'}, R^{25'}, R^{30'} in formula (VIIb) are C1-C10 alkoxyl, alkylthio or alkyl, more preferably C1-C6 alkoxyl, alkylthio or alkyl, and most preferably C1-C4 alkoxyl, alkylthio or alkyl. Said alkoxyl, alkylthio or alkyl may be totally or partially halogenated.

In a most preferred embodiment of the compounds of formulae (VIIa) and (VIIb), A is Si; B, D, B' and D' are selected, independently, from O and S; R¹⁵, R²⁰, R²⁵, and R³⁰ are independently selected from C1-C10 alkoxyl, alkylthio or alkyl, the other of R⁶-R³⁴ being H or halogen, and wherein in formula (VIIb) R^{15'}, R^{20'}, R^{25'}, R^{30'} are selected from C1-C10 alkoxyl, alkylthio or alkyl, the other of R^{6'}-R^{34'} being H or halogen, said alkoxyl, alkylthio or alkyl being optionally partially or totally halogenated; and R³ and R⁴ are identical and are selected from unsubstituted or substituted or aryls, alkyls, heteroaryls, alkenyls, and alkynyls. Optional substituents of said aryls, alkyls, heteroaryls, alkenyls, and alkynyls may be selected from alkyl, alkoxyl, alkylthio, aryl, aroxyl, arylthio, and halogen, wherein said alkyl, alkoxyl, alkylthio, aryl, aroxyl, arylthio may be totally or partially halogenated. In a preferred embodiment, R³ and R⁴ are selected from unsubstituted or substituted or aryls, heteroaryls and alkyls. Preferably, R³ and R⁴ comprise each independently overall (including optional substituents) 1-20 carbons, 0-15 O, S, Se, N and/or P heteroatoms and optionally one or more halogens.

Halogens, for the purpose of this specification, are selected from F, Cl, Br and I. Preferably, halogens, if present, are selected from F and Cl, in particular F.

In case of -NR₁R₂, -O-R_{1,} -S-R₁, alkoxyl and alkylthio, halogens are generally preferably absent on the carbon that is directly connected to the N, O or S heteroatom. For example, in case of -O-R₁, if R₁ is alkyl with two or more carbons, halogens may be present on carbons with the exception of the methylene group connected to O. Halogens may in particular be present on alkyl substituents. If R₁, R₂, alkoxyl and alkylthio as mentioned in this specification are C1 (for example methoxyl, methylthio) they are thus preferably not halogenated. On the other hand, carbons adjacent to the carbon connected to the N, O or S heteroatom may be totally or partially halogenated, for example fluorinated.

In the present specification, reference to a partially halogenated alkoxyl or alkylthio indicates that at least the carbon directly connected to the O and S heteroatom, respectively, is not halogenated, while the remaining carbons may be totally or partially halogenated.

In a preferred embodiment R³ and R⁴ of any one compound selected from the compounds of formulae (Ia), (IIa), (IIIa), (IVa), (Va), (VIa), and (VIIa) are either two separate, identical substituents selected from C1-C20 aliphatic or aromatic substituents, or are fused to form a substituted ring or ring system that is identical to the ring or ring system to which A is bound, thereby resulting in a compound in which A is bound to two identical ring systems. Preferably, R³ and R⁴ are two separate, identical substituents selected from C1-C15 aliphatic, aromatic or heteroaromatic (heteroaryls) substituents.

In a preferred embodiment, R³ and R⁴ are identical and not connected to each other.

In a preferred embodiment R³ and R⁴ of any one compound selected from the compounds of formulae (Ia), (IIa), (IIIa), (IVa), (Va), (VIa), (VIIa) and (VIIIa) are selected from unsubstituted or substituted or aryls, alkyls, alkenyls, alkynyls and heteroaryls. Optional substituents of said aryls, alkyls, alkenyls, alkynyls and heteroaryls may be selected from alkyl, alkoxyl, alkylthio, aryl, aroxyl, arylthio, and halogen. Preferably, R³ and R⁴ comprise each independently overall (including optional substituents) 1-20 carbons, 0-15 O, S, Se, and/or N heteroatoms and optionally one or more halogens, more preferably 1-15 carbons, 0-10 O, S, and/or N heteroatoms and optionally one or more halogens, and most preferably 1-10 carbons optionally one or more halogens but no other heteroatom.

If R³ and R⁴ are substituted, the substituents may be partially or totally halogenated. For example, said alkyl, alkoxyl, alkylthio, aryl, aroxyl, arylthio substituents may contain halogen atoms. Preferred substituents of said substituted aryls, alkyls, alkenyls, alkynyls and heteroaryls, if such substituents are present, are selected from alkyl, partially or totally halogenated alkyl, phenyl, partially and totally halogenated phenyl, alkoxyl, partially halogenated alkoxyl, alkylthio, partially halogenated alkylthio, and halogen. Said alkyl, alkoxyl, alkylthio preferably have from 1-6 carbons. Optional substituents of R³ and R⁴ are preferably selected from C1-C6 alkyl, fluorinated C1-C6 alkyl and alkoxyl.

In a preferred embodiment, R³ and R⁴ are selected from unsubstituted or substituted aryl, heteroaryls, alkenyls and alkyls. Substituents of said aryls, heteroaryls, alkenyls and alkyls, if present, are selected from alkyls, phenyl, alkoxyls, thioalkyl and halogen, wherein said alkyl and phenyl substituents may be partially or totally halogenated and said alkoxyl and thioalkyl substituents may be partially halogenated. Said substituents preferably have from C1-C6 carbons.

Preferably, R³ and R⁴ are selected from substituted or unsubstituted phenyl and alkyl. Optional substituents of said phenyl and alkyl are preferably be selected from C1-C6 alkyls, C1-C6 alkoxyls, C1-C6 thioalkyls and from halogen, wherein said C1-C6 alkyls, alkoxyls and thioalkyls may be halogenated as described elsewhere in this specification.

In a preferred embodiment of the invention, said aromatic ring system comprises two or more S ring heteroatoms, and wherein, in the compounds of formula (IIIa), (IIIb), (Va), (Vb), (VIa), (VIb), (VIIa) and (VIIb), B, D, B', and D' are all S.

In a preferred embodiment of any one compound selected from the compounds of formulae (Ia), (Ib), (IIa), (IIb), (IIIa), (IIIb), (IVa), (IVb), (Va), (Vb), (VIa), (VIb), (VIIa), (VIIb), (VIIIa) and (VIIb), A is a Si atom.

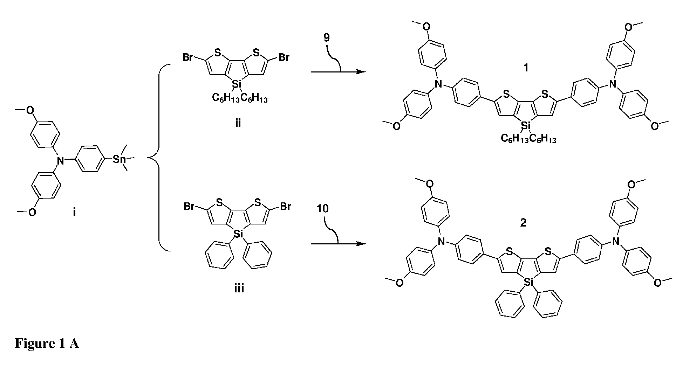

In a preferred embodiment, the compound of the invention is selected from compounds 1 and 2 in Fig. 1A. In an embodiment, the compound is a compound as depicted below:

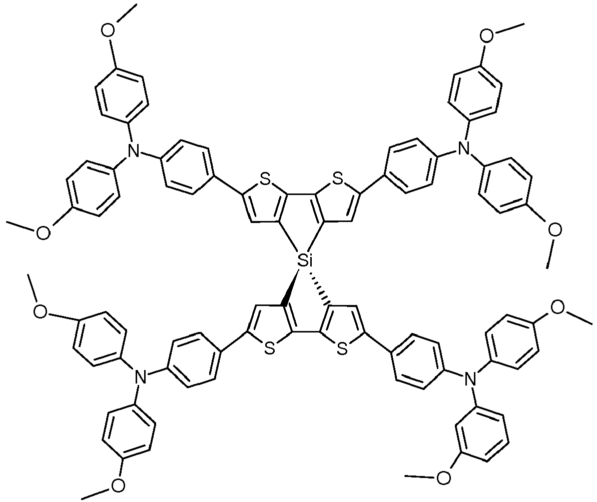

In the structures and/or formulae depicted in the present specification, bond lengths and orientations are not necessarily drawn to scale. One purpose of these structures and/or formulae is to indicate the nature of bonds (double, single, etc, carbon carbon or carbon-heteroatom bonds) and atoms in the compounds of the invention, so that the skilled person can understand what the chemical structures of these compounds are. For example, R⁶-R³⁴ in the structures of formulae (VIIa) and (VIIb) and R^{6'}-R^{34'} in formula (VIIb) are shown so as to be well visible. In these formulae, the bonds by which R⁶-R³⁴ and R^{6'}-R^{34'} are connected to the basic structure are chosen so as to facilitate the recognition of the substituents, and do not correspond necessarily to the bond lengths and orientation in the real molecule.

For the purpose of this specification, any alkyl, alkenyl or alkynyl, if it has 3 or more carbons, may be linear, branched and/or cyclic.

The invention provides optoelectronic and/or electrochemical devices comprising the compounds of the invention. Exemplary devices are solar cells and organic light emitting diodes (OLEDs).

The compounds of the invention are particularly useful as hole transport materials (HTM), for example in optoelectronic and/or electrochemical devices. HTMs are materials in which charges (in particular holes) are transported by electronic motion and not by transport of entire molecules. In other words, holes can move across a material comprising, consisting essentially of or consisting of the material of the invention. Preferred optoelectronic and/or electrochemical devices are solar cells, in particular solid state solar cells, and OLEDs. The compounds of the present invention are particularly useful as materials in HTM layers of organic-inorganic perovskite based solar cells.

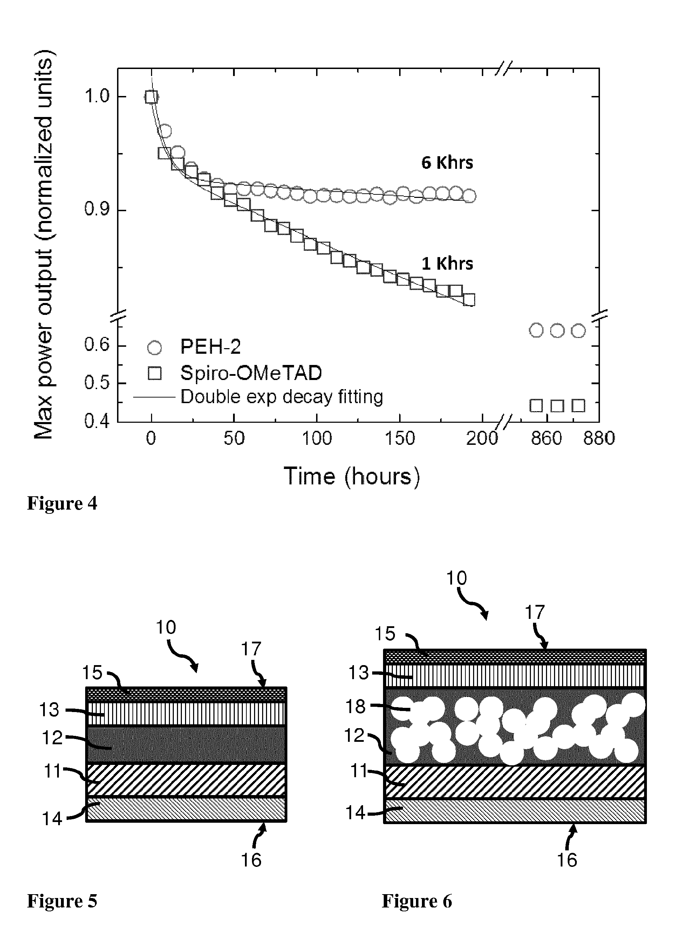

In an embodiment, the invention provides a solar cell 10 as illustrated in Figure 5. The solar cell comprises two opposing sides 16, 17, which may be (arbitrarily) referred to as a first side 16 and a second side 17. The solar cell in accordance with this embodiment preferably comprises a conducting current collector layer 14, an n-type semiconductor layer 11, a light harvester or sensitizer layer 12, a hole transport layer 13 and a conducting current providing layer 15, wherein said hole transport layer 13 is provided between said sensitizer layer 12 and said current providing layer 15, said hole transport layer comprising a compound selected from the compounds of the invention.

In another embodiment, the invention provides a solar cell 10 as illustrated in **Figure 6****,** which comprises a surface increasing structure 18. The remaining reference numerals are as disclosed with respect to Fig. 5.

The current collector 14 preferably comprises a conducting or semiconducting material, such as a conducting organic or inorganic material, such as a metal, doped metal, a conducting metal oxide or doped metal oxide, for example. In a preferred embodiment, the current collector comprises a transparent conductive oxide (TCO).

Generally, the device solar cell of the invention comprises a support layer which may be provided on either one or both of the two sides 16, 17 of the solar cell. In an embodiment, the conducting current collector layer 14 may be part of a support layer, such as conducting plastic or glass, for example. In some embodiments, glass or plastic coated with a TCO current collector is used. These materials, which are commercially available, contain the support as well as the current collector. For example, layer 14 in Figs. 5 and 6 can be regarded as a TCO-coated glass or plastic, wherein the TCO faces layer 11 and the glass or plastic faces the outside of the cell and provide the outer surface or side 16.

Several sensitizers and/or light harvesters, including organic and organometallic dyes, in particular ruthenium dyes, have been described and can be used as light harvester in layer 12 in the solar cells of the invention. In a preferred embodiment of the solar cell of the invention, the sensitizer and/or light harvester comprises and/or consists essentially of an organic-inorganic perovskite. In principle, any suitable organic inorganic perovskite may be used for layer 12. Such organic inorganic perovskites that are useful for solar cells have been disclosed in the literature.

Preferred organic inorganic perovskites are disclosed, for example, in the international application WO 2014/020499, filed on July 24, 2013. The organic-inorganic perovskites disclosed in this application are expressly incorporated herein by reference. More specifically, the organic inorganic perovskite may be selected, for example, from the compounds disclosed from page 10, line 30, through page 17, line 21. This disclosure is expressly incorporated herein by reference.

Furthermore, organic-inorganic perovskites may be selected from those disclosed in international application WO 2013/171517, filed on May 20, 2013, which discloses in particular mixed-anion perovskites, which may also be used for the purpose of the present invention, in particular as disclosed from page 8, the paragraph starting with "The term "perovskite" as defined herein ...", through page 19, including the first paragraph on page 19. This disclosure is expressly incorporated herein by reference.

In an embodiment, the organic-inorganic perovskite comprises compounds selected from of formulae (X) below:

FₖMHₕ (X)

wherein F is an organic, monovalent or bivalent cation selected from primary, secondary, tertiary or quaternary organic ammonium compounds, including N-containing heterorings and ring systems, A having from 1 to 15 carbons and 1 to 10 heteroatoms, E has one or two positively charged nitrogen atoms; k is 1 or two (there may be one or two cations);
M is a metal atom selected from Cu²⁺, Ni²⁺, Co²⁺, Fe²⁺, Mn²⁺, Cr²⁺, Pd²⁺, Zn²⁺, Cd²⁺, Ge²⁺,
Sn²⁺, Pb²⁺, Eu²⁺, and Yb²⁺; preferred metals are Pb and Sn;
and the H are independently selected from Cl⁻, Br⁻, I⁻, NCS⁻, CN⁻, and NCO⁻, preferably from Br⁻ and I⁻; h is 3 or 4;

Preferably, the organic-inorganic perovskite comprised in the device of the invention is neutral, wherein F, M, H, k and h are selected so as to result in a neutral compound.

A preferred organic-inorganic perovskite is methylammonium lead iodide perovskite (CH₃NH₃PbI₃) or the bromide analog CH₃NH₃PbBr₃.

The organic inorganic perovskite layer may be deposited by various techniques for example as disclosed in the international patent application PCT/EP2014/05912, claiming priority of EP13166720.6. In particularly, by sequential deposition, (J. Burschka, N. Pellet, S.-J. Moon, R. Humphry-Baker, P. Gao, M. K. Nazeeruddin, M. Grätzel. Nature 2013, 499, 316).

According to a preferred embodiment, the solar cell of the invention comprises a surface-increasing structure, such as surface increasing structure 18 shown in Fig. 6. The surface increasing structure or scaffold may comprise or consist essentially of one selected from the group of: a semiconductor material and an insulator material. If the surface-increasing structure comprises a semiconductor material, it is preferably an n-type semiconductor material. Traditionally, the surface increasing structure is fabricated from n-type semiconductor nanoparticles, such as TiO₂ nanoparticles.

Surface increasing structures made from non-conducting materials have also been disclosed. For example, the surface-increasing structure may be made from an insulating material. In this case, the absorber or light harvester 12, for example the organic inorganic perovskite layer 12, which is deposited on the surface increasing structure 18, is also in contact with an n-type semiconductor layer 11. In this case, the surface increasing structure 18, which is deposited on the n-type semiconductor layer 11 does thus not continuously cover that n-type semiconductor layer 11, so that the absorber 12 can get in contact with the n-type semiconductor layer 11, too. For example, the n-type semiconductor layer 11 may comprise a dense (also known as "compact") n-type nanoparticle layer, and the surface increasing structure 18 is prepared from nanoparticles of the same n-type semiconductor material as the layer 11.

The surface-increasing structure is preferably structured on a nanoscale. The structures of said surface increasing structure increase the effective surface compared to the surface of the solar cell. Preferably, the surface-increasing structure is mesoporous. The surface-increasing structure is also known as "scaffold structure" or as "surface-increasing scaffold", for example. According to an embodiment, the surface-increasing structure of the solar cell of the invention comprises and/or consists of nanoparticles. The expression "nanoparticles" encompasses particles or particulate elements, which may have any form, in particular also so-called nanosheets, nanocolumns and/or nanotubes, for example. Nanosheets made from anatase TiO₂ have been reported by Etgar et al., Adv. Mater. 2012, 24, 2202-2206, for example. Preferably, the nanoparticles comprise or consist essentially of said semiconductor material.

The nanoparticles preferably have average dimensions and/or sizes in the range of 2 to 300 nm, preferably 3 to 200 nm, even more preferably 4 to 150 nm, and most preferably 5 to 100 nm. "Dimension" or "size" with respect to the nanoparticles means here extensions in any direction of space, preferably the average maximum extension of the nanoparticles. In case of substantially spherical or ellipsoid particles, the average diameter is preferably referred to. In case of, nanosheets, the indicated dimensions refer to the length and thickness. Preferably, the size of the nanoparticles is determined by transmission electron microscopy (TEM) and selected area electron diffraction (SAED) as disclosed by Etgar et al., Adv. Mater. 2012, 24, 2202-2206.

According to an embodiment, the surface-increasing structure comprises, consists essentially of or consists of one or more selected from the group consisting of Si and metal oxide, including transition metal oxides. For example, the surface-increasing structure comprises a material selected from SiO₂, TiO₂, Al₂O₃, ZrO₂ HfO₂, SnO₂, Fe₂O₃, ZnO, WO₃, Nb₂O₅, In₂O₃, Bi₂O₃, Y₂O₃, Pr₂O₃, CeO₂ and other rare earth metal oxides, CdS, ZnS, PbS, Bi₂S₃, CdSe, CdTe, MgTiO₃, SrTiO₃, BaTiO₃, Al₂TiO₅, Bi₄Ti₃O₁₂ and other titanates, CaSnO₃, SrSnO₃, BaSnO₃, Bi₂Sn₃O₉, Zn₂SnO₄, ZnSnO₃ and other stannates, CaZrO₃, SrZrO₃, BaZrO₃, Bi₄Zr₃O₁₂ and other zirconates, combinations of two or more of the aforementioned and other multi-element oxides containing at least two of alkaline metal, alkaline earth metal elements, Al, Ga, In, Si, Ge, Sn, Pb, Sb, Bi, Sc, Y, La or any other lanthanide, Ti, Zr, Hf, Nb, Ta, Mo, W, Ni or Cu.

According to a preferred embodiment, the surface-increasing structure comprises one or more selected from TiO₂ Al₂O₃, SnO₂, ZnO, Nb₂O₅ and SrTiO₃, for example.

According to an embodiment, said surface-increasing structure forms a continuous and/or complete, or, alternatively, a non-continuous and/or non-complete layer. According to an embodiment, said surface increasing structure forms a layer having an overall thickness of 10 to 3000 nm, preferably 12 to 2000 nm, preferably 15 to 1000 nm, more preferably 20 to 500 nm, still more preferably 50 to 400 nm and most preferably 100 to 300 nm.

For the purpose of the present specification, a "continuous layer" or a "complete layer" is a layer that covers an adjacent layer, such as the conductive support layer, completely so that there can be no physical contact between the two layers separated by the continuous or complete layer and adjacent to said continuous or complete layer. For example, one, two or all selected from the groups consisting of the perovskite layer, the n-type semiconductor layer and the hole transport layer are preferably continuous layers. Preferably, the underlayer, if present, is also a complete layer. The current collector and/or the conductive support are preferably also continuous layers. If the surface increasing structure is non-continuously and/or non-completely provided on said conductive support layer, the perovskite layer does or could get in direct contact with said current collector and/or underlayer.

The surface increasing structure may be prepared by screen printing, spin coating, slot die coating, blade coating, dip coating or meniscus coating, or physical vapor deposition process, for example as is conventional for the preparation of porous semiconductor (e.g. TiO₂) surfaces in heterojunction solar cells, see for example, Noh et al., Nano Lett. 2013, 7, 486-491 or Etgar et al., Adv. Mater. 2012, 24, 2202-2206. The preparation of nanoporous semiconductor structures and surfaces has been disclosed, for example, in EP 0333641 and EP 0606453.

If the surface increasing structure is made of an n-type semiconductor material, the working electrode and/or photoanode of the solar cell of the invention is the assembly of the light-harvesting perovskite and the surface increasing semiconductor material.

In other embodiments, a surface increasing structure as defined above is absent.

The n-type semiconductor layer 11 can be made from n-type semiconductor materials listed above with respect to the surface increasing structure 18. Instead of metal oxides as discussed above, n-type semiconducting polymers may be used, for example, in particular in polymer-based solar cells. This possibility applies in particular if a surface increasing structure made from metal-oxide nanoparticles is absent. Accordingly, layer 11 in Figs 5 and 6, for example, may be an n-type organic material layer as electron transport material (ETM). Organic ETMs can be chosen from a wide variety of conducting materials for charge collection. Exemplary organic ETMs are fullerene and PCBM (Phenyl-C61-butyric-acid-methyl-ester).

### Examples

### Example 1: Synthesis of compound 1 (PHE-1)

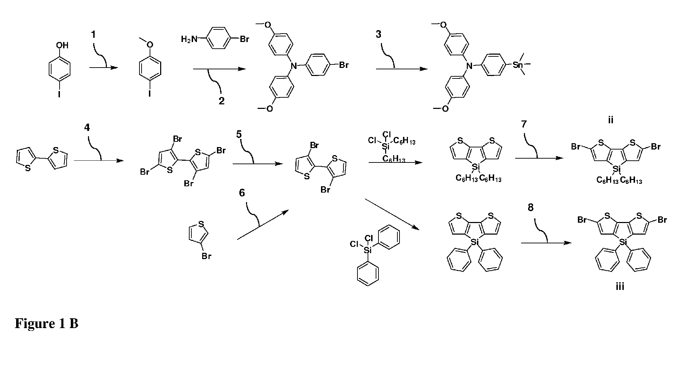

The complete synthesis of exemplary compounds of the invention is illustrated in the schemes shown in Figures 1A and 1B.

The reference numerals in Figures 1A and 1B represent the following process conditions:
1: K₂CO₃, CH₃I (DMF); 2: 1,10-phenanthroline, CuCl₂, KOH (TOI); 3: BuLi(2.5M), Trimethyltinchloride (THF); 4: Br₂, CHCl₃, AcOH; 5: Zn, HCl (EtOH), 6: LDA, CuCl; 7: NBS (DMF); 8: NBS (DMF); 9: Pd(PPh₃)₄ (Tol); 10: Pd(PPh₃)₄ (Tol).

To 4-bromo-N,N-bis(4-methoxyphenyl)aniline (0.55 g, 1.04 mmol) in dry THF under nitrogen atmosphere, was added drop-wise n-BuLi (0.68 ml, 2.5 M in hexane) at -78 °C. After 30 min stirring at -78 °C, 1.71 ml of trimethyltin chloride (1.0 M in THF solution) was added slowly to the reaction solution at -78 °C (reference numeral 3). The temperature of the solution was warmed to room temperature and the reaction was stirred overnight. Then, the reaction was quenched with brine. The solution was extracted with diethylether, dried with MgSO₄. Compound *i* was obtained without any purification. Compound *i* and *ii* (0.33 g, 0.5 mmol), Pd(PPh₃)₄ (0.077 g, 0.067 mmol), and anhydrous toluene (50 ml) were added to a 125 mL flame-dried Schlenk flask with a condenser under a nitrogen atmosphere. The reaction mixture was heated to reflux for 1 day. The reaction mixture was then cooled to room temperature. The organic layer was separated and dried over anhydrous MgSO₄. The solvent was removed in vacuum overnight. The orange product was purified by column chromatography. Yield: 60 %. MS: m/z 968.4 [M+]. ¹H NMR (400 MHz, CDCl₃): δ 7.43 (d, J = 8.0 Hz, 4H), 7.17 (S, 2H), 7.13 (d, J = 8 Hz, 8H), 6.95 (d, J = 8.0 Hz, 4H), 6.86 (d, J = 8.0 Hz, 8H), 3.83 (s, 12H), 1.44 (m, 4H), 1.37 (m, 4H), 1.32 (m, 8H), 0.96 (m, 4H), 0.88 (t, 6H). ¹³C NMR (100 MHz, CDCl₃): δ 155.9, 147.8, 147.5, 145.0, 142.4, 140.7, 127.0, 126.5, 126.2, 124.3, 120.8, 114.7, 55.5, 32.9, 31.4, 24.2, 22.6, 14.1, 11.9.

### Example 2: Reparation of compounds 1 (PHE-2)

Exemplary compound **PEH**-**2** was synthesized following a procedure similar to what we used for **PEH-1,** except that *iii* (0.3 g, 0.59 mmol) was used in place of *ii.* Yield: 65 %. MS: m/z 952.2 [M+]. ¹H NMR (400 MHz, CDCl₃): δ 7.71 (d, J = 8.0 Hz, 4H), 7.45-7.37 (m, 10H), 7.33 (S, 2H), 7.10 (d, J = 8 Hz, 8H), 6.94 (d, J = 8.0 Hz, 4H), 6.86 (d, J = 8.0 Hz, 8H), 3.83 (s, 12H). ¹³C NMR (100 MHz, CDCl₃): δ 156.1, 148.2, 135.8, 135.4, 134.8, 131.8, 130.3, 128.5, 128.2, 127.8, 127.4, 126.9, 126.6, 120.2, 114.9, 55.5.

### Example 3: Reparation of solar cells

Devices were fabricated on fluorine doped tin oxide (FTO) coated glass substrates. The substrates were cleaned sequentially with Hellmanex in ultrasonic bath for 30 min, then washed with acetone, isopropanol and finally cleaned with oxygen plasma for 5 min. A 30 nm TiO₂ compact layer was deposited on FTO via spray pyrolysis at 450°C from a precursor solution of titanium diisopropoxide bis(acetylacetonate) in anhydrous ethanol. After the spraying, the substrates were left at 450°C for 45 min, then they were left to cool down to room temperature. Mesoporous TiO₂ layer was deposited by spin coating for 20 s at 4000 rpm with a ramp of 2000 rpm s⁻¹, using 30 nm particle paste (Dyesol) diluted in ethanol to achieve 150 nm thick layer. After the spin coating, the substrate was immediately dried at 100°C for 10 min and then sintered again at 500°C for 30 min, under dry air flow.

Upon cooling to room temperature, the perovskite layer was deposited in a nitrogen-filled glovebox by spin coating the perovskite precursor solution. The latter was prepared dissolving a stoichiometric amount (1:1 molar ratio) of lead iodide and methyl ammonium iodide in dimethylsulfoxide at a concentration of 1.1 M of each component. The spin coating program includes two steps, first 1000 rpm for 10 s with a ramp of 200 rpm s⁻¹, then 6000 rpm for 30 s with a ramp of 2000 rpm s⁻¹. 10 s before the end of the spin-coating program, chlorobenzyl was gently dropped on the spinning substrate for 2 s using an automatic dispenser. The substrate was then heated at 90°C for 1 h on a hotplate in the nitrogen-filled glovebox.

The HTMs were subsequently deposited on the top of the perovskite layer by spin coating from solution at 4000 rpm for 20 s with a ramp of 2000 rpm s⁻¹. The HTM solutions were prepared dissolving the compounds (**PEH-1, PEH**-**2** or spiro-OMeTAD) in chlorobenzyl at concentration of 60 mM, with the addition of 50 mol% of bis(trifluoromethanesulfonyl)imide (Aldrich) from a stock solution of 1.8 M in acetonitrile), 330 mol% of tert-butylpyridine (Aldrich) and 2 mol% of Tris(2-(1H-pyrazol-1-yl)-4-tert-butylpyridine)- cobalt(III) Tris(bis(trifluoromethylsulfonyl)imide) (Dyenamo) from a stock solution 0.25 M in acetonitrile. Finally, 80 nm of gold was deposited by thermal evaporation under high vacuum, using a shadow masking to pattern the electrodes.

### Example 4: Characterisation of exemplary compounds PEH-1 and PEH-2

Absorption spectral measurements were recorded using JASCO V630 UV-visible spectrophotometer with compounds in CH₂Cl₂ solution. Thermal analysis was conducted using Sinco TGA N-1000 under nitrogen atmosphere. Cyclic voltammetry was measured with an Autolab Eco Chemie cyclic voltammeter in dichloromethane solvent. The experimental setup consisted of a glassy carbon working electrode, platinum wire counter electrode and platinum reference electrode. Oxygen was removed by bubbling with pure nitrogen gas for 5 min at room temperature. The system was initially calibrated with ferrocene/ferrocenium (Fc/Fc⁺) redox couple. Redox potential of HTM's measured in CH₂Cl₂ with 0.1 M (n-C₄H₉)₄N-PF₆ (tetrabutylammonium hexafluorophosphate) at a scan rate of 100 mV s-1.

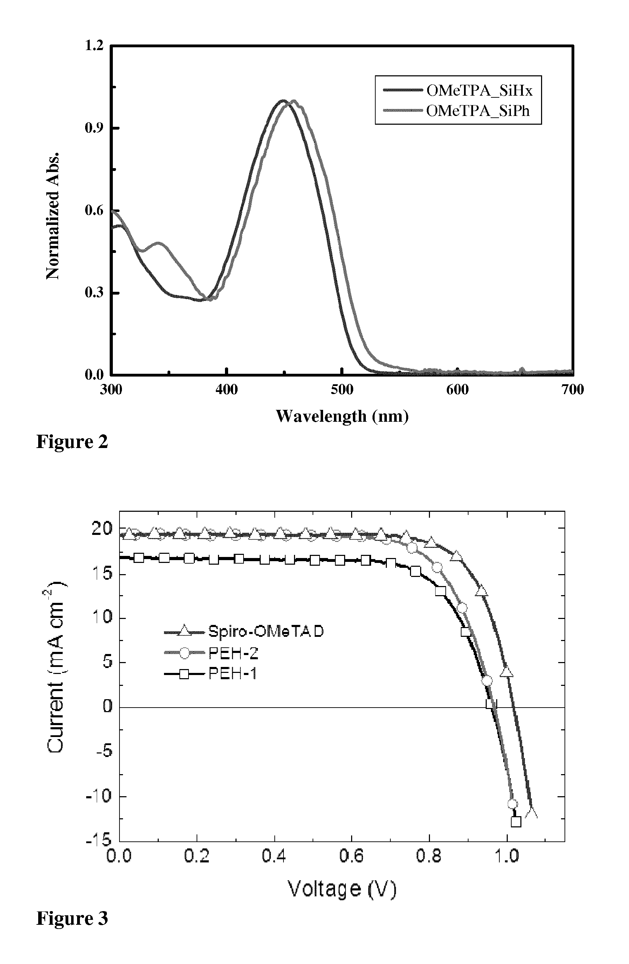

Absorption spectra of OMeTPA_SiHx (PEH-1) and OMeTPA_SiPh (PEH-2) are shown in **Figure 2****.** Both the OMeTPA-Si derivatives showed similar spectra with a broad absorption in the ultraviolet region and a strong absorption band in the visible region. The latter peak around 450 nm with PEH-2 trace was red shifted compared to PEH-1. This shift suggests that the benzyl groups attached to sp³ silicon in PEH-2 stabilizes more effectively the first molecular excited state compared to the alkyl chains functionalized silicon in PEH-1. **Table 1** summarizes optoelectronic properties of the compounds PEH-1 and PEH-2.

**Table 1: Electrochemical parameters extracted from data in Figure 2 and from cyclic voltammogram traces (not shown).**

| | *E₀₋₀* (eV)^{[a]} | *E*⁰_{OX} (V)^{[b]} | *E*_{HOMO} (eV)^{[c]} | *E*_{LUMO} (eV)^{[d]} |
|---|---|---|---|---|
| PEH-1 | 2.43 | 0.035 | -4.83 | -2.40 |
| PEH-2 | 2.37 | 0.045 | -4.84 | -2.47 |

| | | | | |
|---|---|---|---|---|
| [a] Zero-zero transition (*E*₀₋₀) was estimated from the threshold of the absorption spectra in dichloromethane. [b] Redox potential (*E*⁰_{OX}) was measured vs. Fc/Fc⁺ in dichloromethane with 0.1 M tetrabutylammonium hexafluorophosphate, scan rate of 100 mVs⁻¹. [c] The energy of the highest occupied molecular orbital (E_{HOMO}) was calculated as -1.4 • *E*⁰_{OX}(V) - 4.6. [d] The energy of the lowest unoccupied molecular orbital (*E*_{LUMO}) was calculated as *E*₀₋₀ -*E*_{OX}*.* | | | | |

### Example 5: Characterisation of solar cells

Current-voltage characteristics were measured under AM 1.5 simulated sunlight with a potentiostat (Keithley). The light intensity was measured for calibration before each device with an NREL certified KG5 filtered Si reference diode. The solar cells were masked with a metal aperture of 0.16 cm² to define the active area. The current-voltage curves were recorded scanning at 0.01 V s⁻¹ from forward bias to short circuit condition.

**Figure 3** shows the JV characteristics of the best solar cells prepared with OMeTPA-Si derivatives and spiro-OMeTAD in a single experiment. In Table 2, the device performance parameters are summarized, as extracted from fitting of the JV curves in Figure 3, and the light intensity measured right before each JV scan. We note that PEH-2 allowed collecting nearly identical short circuit current (J_{SC}) than spiro-OMeTAD, while the J_{SC} for the PEH-1 device was over 2.5 mA cm⁻² lower. Both the OMeTPA-Si devices showed similar open circuit voltage (V_{OC}), which was about 30 mV lower than spiro-OMeTAD. This can be in part rationalized considering that the E_{HOMO} we measured for both OMeTPA-Si derivatives were about 100 meV higher than the values usually measured for the spiro-OMeTAD. From the fitting of the JV curves in Figure 3 to an ideal diode model, we extracted the device series resistance (R_{S}). The R_{S} values reported in Table 2 showed that the OMeTPA-Si devices have higher R_{S} than spiro-OMeTAD, which can be in part responsible for the lower fill factor (FF).

The calculated PCEs are 15.2% for spiro-OMeTAD and 13.5 and 11.7% for PEH-2 and PEH-1, respectively.

**Table 2 Solar cell performance parameters: short circuit photocurrent (J_{SC}), power conversion efficiency (PCE), open circuit voltage (V_{OC}), fill factor (FF) and series resistances (R_{S}).**

| | *J_{SC} (mA cm⁻²)* | *V_{OC} (V)* | *FF* | *R_{S} (Ohm cm⁻²)* | *PCE (%)* | *Light intensity (mW cm⁻²)* |
|---|---|---|---|---|---|---|
| Spiro-MeTAD | 19.4 | 1.02 | 0.76 | 44 | 15.2 | 98.0 |
| PEH-2 | 19.4 | 0.97 | 0.72 | 87 | 13.5 | 99.9 |
| PEH-1 | 16.8 | 0.96 | 0.72 | 103 | 11.7 | 100.0 |

### Example 6: Comparison of stability of solar cells

Solar cells were prepared as described in Example 3. Stability was determined by tracking the steady-state maximum power output (MPO) of individual cells. The applied voltage was automatically adjusted to continuously keep the devices at the maximum power point. After preparation, devices were aged in inert gas condition and under UV-filtered light. We note that there is no trace for PEH-1 since we could not get reproducible MOP decays for these devices. As we observed for a number of different experiments, the MPO traces of PEH-2 and spiro-OMeTAD in this experiment showed a double exponential decay trend within the first 200 hours of testing **(****Figure 4****).** In particular, they have a very similar early time decay, which can be well modelled using the same fast half-life (5.3 hrs) calculated by averaging the MPO decays of three different spiro-OMeTAD devices(data not shown). We assigned this decay to the reported formation of shunting pathways caused by metal electrode migrating within the HTM and contacting the perovskite layer. The fact that both devices exhibit the same fast half-life constant suggests that this degradation mechanism is active regardless of the particular HTM used. However, it saturates within few hours and thus impacts only marginally the long-term stability. More interestingly, the second and longer lasting decay regime shows that the PEH-2 device degrades with a half-life 6 times longer than that of spiro-OMeTAD. In Figure 4, we also report the MPO traces collected after 850 hrs, which decays to 0.65 and 0.45 of the initial value for PEH-2 and spiro-OMeTAD, respectively. We note that in the time window between 200 and 850 hrs the devices were kept under light and inert gas condition, but not always under applied bias voltage. Nevertheless, the experimental values are in good agreement with the trend we found in the first 200 hrs of testing and they confirmed that the PEH-2 device degraded significantly less than spiro-OMeTAD. We highlight that devices were prepared in a single experiment following the same procedures and both the HTMs were prepared using the same chemical doping composition, which thus cannot justify any difference in stability. In addition, both the HTMs have the same triphenylamines donor units, which are connected by silolothiophene or spiro bridge in PEH-2 and spiro-OMeTAD respectively. This apparently minor difference impacted dramatically the device lifetime, demonstrating that the HTMs of the present invention have a key role in the device stability.

## Claims

1. Use as a hole transport material of a compound selected from compounds of formula (Ia) and formulae (Ib): 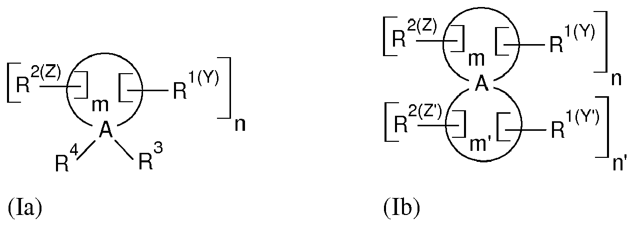 wherein the ring in formula (Ia) and the rings in formula (Ib) represent each an aromatic ring or ring system optionally comprising one or more O, S and/or N ring heteroatoms; wherein A is part of said aromatic ring or ring systems and is selected from a Si and a C atom, preferably Si;
R^{1(Y)} and R^{2(Z)}, are substituents or hydrogen atoms bound to said aromatic ring or ring system; R^{1(Y')}, and R^{2(Z')} in formulae (Ib), are independently defined as R^{1(Y)} and R^{2(Z)};
n and m, are integers, wherein n+m and is the maximum number of substituents that can be supported on the respective aromatic ring or ring system; wherein, in formulae (Ib), n' and m' and n'+m' are defined, independently, as n, m, and n+m, respectively;
Y and Z are, independently Y from Z, consecutive integers from the set of integers {1...n} and {1...m}, respectively, so that there are n+m substituents or H R¹⁽¹⁾ (Y=1) to R¹⁽ⁿ⁾ (Y=n) and R²⁽¹⁾ (Z=1) to R^{2(m)} (Z=m);
wherein Y' and Z' are, independently Y' from Z', consecutive integers from the set of integers {1...n'} and {1...m'} so that there are n'+m' substituents or H R^{1(1')} (Y'=1) to R^{1(n')} (Y'=n') and R^{2(1')} (Z'=1) to R^{2(m')} (Z'=m');
wherein R¹⁽¹⁾ to R¹⁽ⁿ⁾ and R²⁽¹⁾ to R^{2(m)} are independently selected from H, and from substituents comprising 1-50 carbons, 0-20 O, S, Se, N and/or P heteroatoms and optionally one or more halogens;
wherein R^{1(1')} to R^{1(n')} and R^{2(1')} to R^{2(m')} in formulae (Ib) are independently selected from H and from substituents comprising 1-50 carbons, 0-20 O, S, Se, N and/or P heteroatoms and optionally one or more halogens;
with the proviso that at least one of R^{1(Y)}, at least one of R^{2(Z)}, at least one of R¹⁽¹⁾ to R¹⁽ⁿ⁾, and at least one of R²⁽¹⁾ to R^{2(m)} is a substituent different from H;
with the proviso that, in formulae (Ib), at least one of R^{1(Y')}, at least one of R^{2(Z')}, at least one of R^{1(1')} to R^{1(n')}, and at least one of R^{2(1')} to R^{2(m')} is a substituent different from H; and,
R³ and R⁴ are substituents comprising each independently overall from 1-35 carbons 0-20 O, S, Se, N and/or P heteroatoms and optionally one or more halogens, wherein R³ and R⁴ may be connected to each other and form a substituted or unsubstituted ring or ring system bound to said atom A.

2. The use of claim 1, wherein said compound is a compound selected from the compounds of formula (IIa) and (IIb): 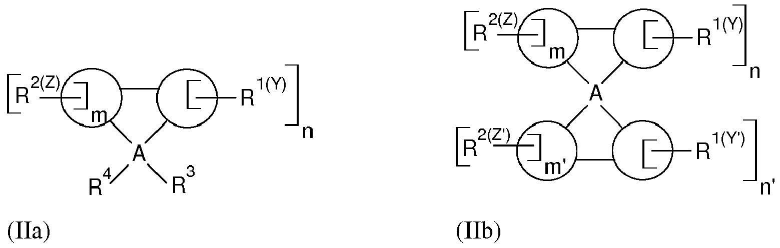 wherein the two rings carrying R^{1(Y)} and R^{2(Z)}, respectively, are connected to each other thereby forming an aromatic ring system containing A, wherein the same applies to the two rings carrying R^{1(Y')} and R^{2(Z')} in formula (IIb);
A is connected to each of said two rings so as to be part of a central ring fused to each of said two rings; and,
wherein n, m, R^{1(Y)} and R^{2(Z)}, R³ and R⁴, and n', m', R^{1(Y')} and R^{2(Z')}, respectively, are as defined in claim 1.

3. The use of any one of the preceding claims, wherein said compound is selected from compounds of formulae (IIIa), (IIIb), (IVa) and (IVb): 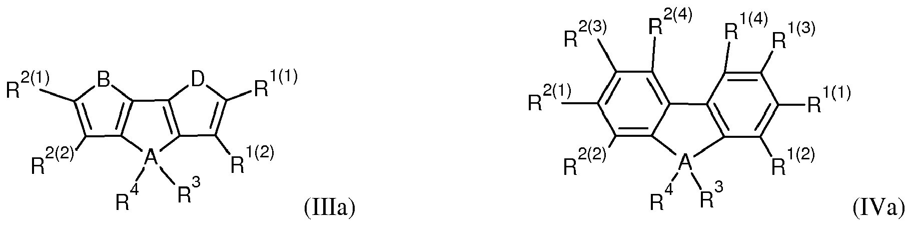 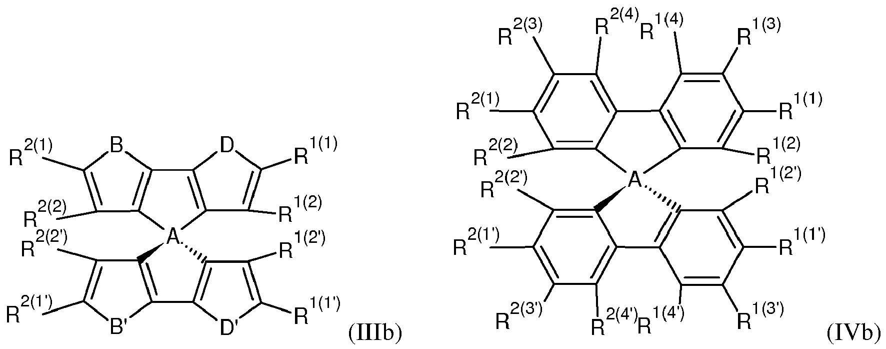 wherein R³ and R⁴ are as defined in claim 1;
A in formulae (IIIa), (IIIb) and (IVa) is selected from Si and C; and A in formula (IVb) is Si;
R¹⁽¹⁾-R¹⁽⁴⁾ and R²⁽¹⁾-R²⁽⁴⁾, in as far as present, are defined independently as R¹⁽¹⁾ to R¹⁽ⁿ⁾ and R²⁽¹⁾ to R^{2(m)} in claim 1;
R^{1(1')}-R^{1(4')} and R^{2(1')}-R^{2(4')}, in as far as present, are defined as R^{1(1')} to R^{1(n')} and R^{2(1')} to R^{2(m')} in claim 1;
B, D, B' and D' are selected, independently, from O, S, and from N-R¹⁽³⁾ (for D), N-R^{1(3')} (for D'), N-R²⁽³⁾ (for B), and N-R^{2(3')} (for B'), respectively.

4. The use of any one of the preceding claims, wherein:
i) R^{1(Y)} and R^{2(Z)} in formulae (Ia), (Ib), (IIa), and (IIb);
viii) R¹⁽¹⁾ to R¹⁽ⁿ⁾ and R²⁽¹⁾ to R^{2(m)} in claim 1;
ix) R¹⁽¹⁾-R¹⁽²⁾, R²⁽¹⁾-R²⁽²⁾ and, if present R¹⁽³⁾ and R²⁽³⁾, in formulae (IIIa) and (IIIb);
x) R¹⁽¹⁾-R¹⁽⁴⁾ and R²⁽¹⁾-R²⁽⁴⁾ in formulae (IVa) and (IVb);
xi) R^{1(Y')} and R^{2(Z')} in formulae (Ib) and (IIb);
xii) R^{1(1')} to R^{1(n')} and R^{2(1')} to R^{2(m')} in claim 1;
xiii) R^{1(1')}-R^{1(2')}, R^{2(1')}-R^{2(2')} and, if present, R^{1(3')} and R^{2(3')} in formulae (IIIb);
viii) R^{1(1')}-R^{1(4')} and R^{2(1')}-R^{2(4')} in formulae (IVb);
are, independently, selected from H, substituted or unsubstituted aryls, heteroaryls, alkyls, alkenyls, alkynyls, and from substituents of formulae -O-R_{1,} -S-R₁ and -NR₁R₂;
with the proviso that in the compounds of formulae (IIIa) and (IIIb), R¹⁽³⁾ and R²⁽³⁾, if present, are not selected from -O-R₁, -S-R₁ and -NR₁R₂; and, with the proviso that in the compound of formulae (IIIb), R^{1(3')} and R^{2(3')}, if present, are not selected from -O-R₁, -S-R₁ and -NR₁R₂;
wherein:
at least one of R^{1(Y)}, at least one of R^{2(Z)}, at least one of R^{1(Y')}, at least one of R^{2(Z')};
at least one of R¹⁽¹⁾ to R¹⁽ⁿ⁾, at least one of R²⁽¹⁾ to R^{2(m)}, at least one of R^{1(1')} to R^{1(n')}, at least one of R^{2(1')} to R^{2(m')},
at least one of R¹⁽¹⁾-R¹⁽²⁾ in formulae (IIIa) and (IIIb), at least one of R²⁽¹⁾-R²⁽²⁾ in formulae (IIIa) and (IIIb), at least one of R^{1(1')}-R^{1(2')} in formula (IIIb), at least one of R^{2('1)}-R^{2('2)} in formula (IIIb),
at least one of R¹⁽¹⁾-R¹⁽⁴⁾ in formulae (IVa) and (IVb), at least one of R²⁽¹⁾-R²⁽⁴⁾ in formulae (IVa) and (IVb), at least one of R^{1(1')}-R^{1(4')} in formula (IVb), and at least one of R^{2(1')}-R^{2(4')} in formula (IVb),
is different from H;
A) wherein substituents of said aryls, heteroaryls, alkyls, alkenyls, alkynyls, if present, are independently selected from -NR₁R₂, -O-R_{1,} -S-R₁, aryls, heteroryls, alkyls, alkenyls, and alkynyls;
B) wherein R₁ and R₂ are independently selected from substituted or unsubstituted aryl, heteroaryl, alkyl, alkenyl, and alkynyl,
wherein any aryl, heteroryl, alkyl, alkenyl, and alkynyl may be partially or totally halogenated.

5. The use of claim 4, wherein one or more of said at least one substituents that is different from H is selected from substituents of formula (1) below: 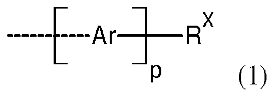 wherein the dotted line represents a covalent single bond by which the substituent of formula (1) is connected to the aromatic ring or ring system,
p is selected from an integer of 1-3 and from 0; and,
R^{X} is selected from -NR₁R₂, H, -O-R₁, -S-R₁, substituted and unsubstituted aryl, heteroaryl, alkyl and alkenyl;
wherein R₁ and R₂ are independently selected from substituted or unsubstituted aryl, heteroaryl, alkyl, alkenyl, and alkynyl, wherein, if said aryl, heteroaryl, alkyl, alkenyl, and alkynyl is substituted, substituents are selected from alkoxyl, alkylthio, phenoxyl, alkyl and halogen;
Ar is an monocyclic, bicyclic or polycyclic aromatic moiety, which comprises 0, 1 or 2 ring O, S and/or N heteroatoms, wherein Ar may comprise other substituents (other than H) in addition to R^{X},
wherein any aryl, heteroryl, alkyl, alkenyl, phenoxyl and alkynyl may be partially or totally halogenated and any alkoxyl and alkylthio may be partially halogenated.

6. The use of any one of the preceding claims, wherein said compound is a compound selected from the compounds of formulae (Va) and (Vb): 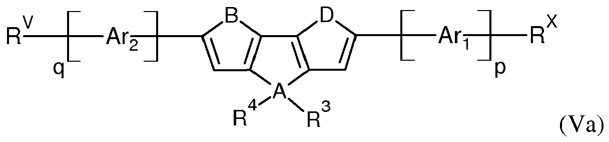 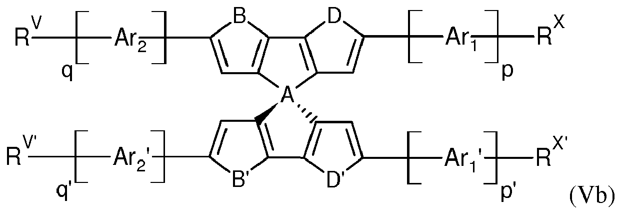 wherein R³ and R⁴ are as defined in claim 1;
wherein A is selected from Si and C, preferably Si;
B, D, B' and D' are selected, independently, from O, S, and from N-R¹⁽³⁾ (for D), N-R^{1(3')} (for D'), N-R²⁽³⁾ (for B), and N-R^{2(3')} (for B'), respectively, as defined in claim 3 and claim 1;
p, q, p', q' are independently selected from integers of 1-3 and from 0;
R^{X}, R^{V}, R^{X'} and R^{V'}, are also present if any one of p or q or p' or q', respectively, is 0, and are selected independently from -NR₁R₂, H, -O-R₁, -S-R₁, substituted and unsubstituted aryl, heteroaryl, alkyl, alkenyl and alkynyl;
wherein R₁ and R₂ are independently selected from substituted or unsubstituted aryl, heteroaryls, alkyl, alkenyl, and alkynyl;
wherein, if any one of said aryl, heteroaryl, alkyl, alkenyl, alkynyl of R^{X}, R^{V}, R^{X'}, R^{V'} and of R₁ and R₂ is substituted, substituents are selected from alkoxyl, alkylthio, alkyl and halogen, wherein said alkoxyl, alkylthio and alkyl may be partially halogenated and said alkyl may be totally halogenated;
Ar₁, Ar₂, Ar₁' and Ar₂' are selected from monocyclic, bicyclic and polycyclic aromatic moieties, which comprise 0, 1 or 2 ring O, S and/or N heteroatoms and which may comprise other substituents (other than H) in addition to R^{X}, R^{V}, R^{X'} and R^{V'}, respectively;
wherein if p and/or q > 1, each Ar₁ and each Ar₂, may be identical or different from the other or others Ar₁ or Ar₂, respectively, and, if p' and/or q' > 1, each Ar₁' and each Ar₂', may be identical or different from the other or others Ar₁' or A₂', respectively.

7. The compound of any one of the preceding claims, wherein said compound is selected from compounds of formulae (VIa) or (VIb): 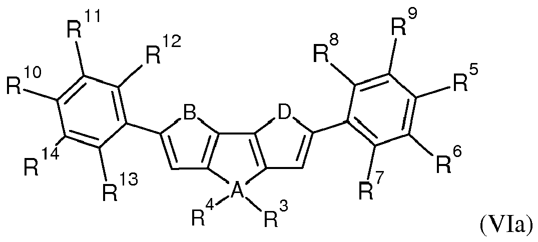 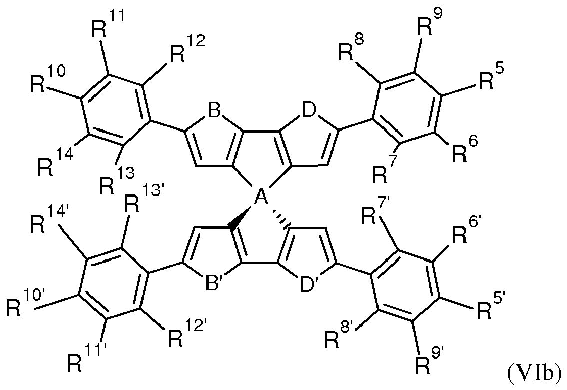 wherein A is selected from Si and C, preferably Si;
R³ and R⁴ are as defined in claim 1;
B, D, B', and D' are as defined in claim 3 and claim 1;
A) wherein any one of the substituents R⁵-R¹⁴ and R^{5'}-R^{14'} is independently selected from H, -NR₁R₂, -O-R₁, -S-R₁, substituted and unsubstituted aryl, heteroaryl, alkyl, alkenyl, alkynyl and halogen; with the proviso that:
in formulae (VIa) and (VIb), at least one of R⁵-R⁸ and at least one of R¹⁰-R¹⁴ is different from H and halogen; and, in formula (VIb), at least one of R^{5'}-R^{8'} and at least one R^{10'}-R^{14'} is different from H and halogen;
a) wherein optional substituents of said aryl, heteroryl, alkyl, alkenyl, alkynyl under A) are selected from substituents of formulae -O-R_{1,} -S-R₁, -NR₁R₂, alkyl and halogen;
b) wherein R₁ and R₂ are independently selected from substituted or unsubstituted aryl, heteroaryl, alkyl, alkenyl, and alkynyl;
(i) wherein, if any one of said aryl, heteroaryl alkyl, alkenyl, and alkynyl, under b) is substituted, such substituents are independently selected from alkoxyl, alkylthio, alkyl, phenoxyl and halogen, wherein said alkoxyl and alkylthio may be partially halogenated and said alkyl and phenoxyl may be partially or totally halogenated;
wherein any one of said aryl, heteroryl, alkyl, alkenyl, alkynyl under a) and b) may be totally or partially halogenated.

8. The compound of any one of the preceding claims, which is selected from compounds of formulae (VIIa) or (VIIb) below,
wherein A is selected from Si and C, preferably Si;
R³ and R⁴ are as defined in claim 1;
B, D, B', and D' are as defined in claim 3 and claim 1;
wherein any one of R⁶-R³⁴ in formulae (VIIa) and (VIIb), and any one R^{6'}-R^{34'} in formula (VIIb), respectively, is independently selected from H, alkoxyl, alkylthio, alkyl, phenoxyl and halogen, and wherein, if any one of R⁶-R³⁴ that is alkoxyl or alkylthio and that is other than methoxyl and methylthio, may be partially halogenated, and any one of R⁶-R³⁴ that is alkyl may be partially or totally halogenated;

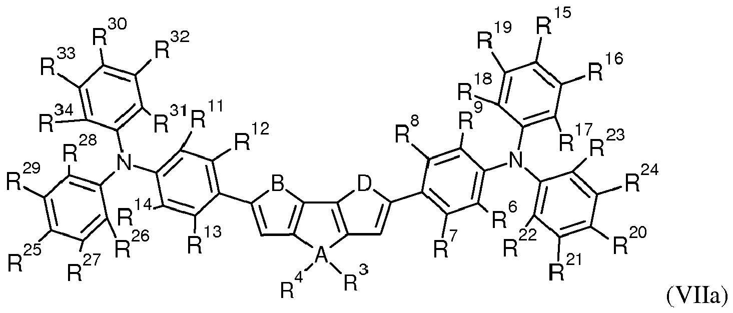

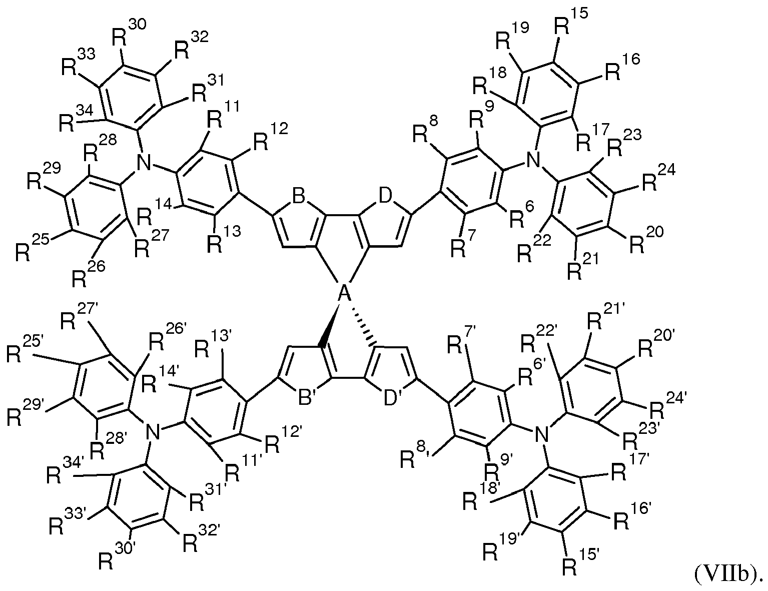

9. The use of claim 8, wherein, in formula (VIIa) and (VIIb), R¹⁵, R²⁰, R²⁵, and R³⁰ are independently selected from alkoxyl, alkylthio or alkyl, the other of R⁶-R³⁴ being H or halogen, and wherein in formula (VIIb) R^{15'}, R^{20'}, R^{25'}, R^{30'} are selected from alkoxyl, alkylthio or alkyl, the other of R^{6'}-R^{34'} being H or halogen, wherein said alkoxyl and alkylthio, if it is other than methoxyl and methylthio, may be partially halogenated, and wherein said alkyl may be partially or totally halogenated.

10. The use of any one of the preceding claims, wherein R³ and R⁴ are selected from unsubstituted or substituted aryls, heteroaryls, alkenyls and alkyls.

11. The use of claim 10, wherein substituents of said aryls, heteroaryls, alkenyls and alkyls, if present, are selected from alkyls, alkoxyls, thioalkyl, phenyl and halogen, wherein said alkyl and phenyl substituents may be partially or totally halogenated and said alkoxyl and thioalkyl substituents may be partially halogenated.

12. The use of any one of the preceding claims, wherein said ring system comprises two or more S ring heteroatoms, and wherein, in the compounds of formula (IIIa), (IIIb), (Va), (Vb), (VIa), (VIb), (VIIa) and (VIIb), B, D, B', and D' are S.

13. The use of any one of the preceding claims, wherein A is a Si atom.

14. The use of any one of the preceding claims, wherein said compounds are selected from 5,5'-Bis[N,N-di(4-methoxyphenyl)aniline]-3,3'-dihexylsilylene-2,2'-bithiophene, 5,5'-Bis[N,N-di(4-methoxyphenyl)aniline]-3,3'-diphenylsilylene-2,2'-bithiophene, and 2,2',6,6'-Tetrakis-{N,N-di(4-methoxyphenyl)aniline}-4,4'-Spirobi[dithienosilole].

15. An optoelectronic and/or electrochemical device comprising a compound selected from the compounds as defined in any one of claims 1-14.

16. The device of claim 14, which is a solar cell, preferably an organic-inorganic perovskite or dye-sensitized solar cell, preferably a solid state solar cell.

17. The device of any one of claims 14-15, which comprises a p-type semiconductor and/or hole transport layer comprising a hole transport material comprising a compound selected from the compounds of formulae (Ia), (Ib), (IIa), (IIb), (IIIa), (IIIb), (IVa), (IVb), (Va), (Vb), (VIa), (VIb), (VIIa), and (VIIb) as defined in any one of claims 1-13.

18. The device (1) of any one of claims 14-16, which comprises a conducting current collector layer (5), a n-type semiconductor layer (2), an organic-inorganic perovskite layer (3), a hole transport layer (4) and a conducting current providing layer (6), wherein said hole transport layer (4) is provided between said perovskite layer (3) and said current providing layer (6), said hole transport layer comprising a hole transport material comprising the compound as defined in any one of claims 1-13.

19. A compound selected from the compounds of formulae (Ia), (Ib), (IIa), (IIb), (IIIa), (IIIb), (IVa), (IVb), (Va), (Vb), (VIa), (VIb), (VIIa),ad (VIIb) as defined in any one of claims 1-13.
